# EUROPEAN PATENT APPLICATION

(11) **EP 3 012 807 A1**
(43) Date of publication of application: **27.04.2016**
(21) Application number: 14814126.0
(22) Date of filing: 06.06.2014
(51) Int. Cl.: G06T 19/00, G06F 17/50

(54) **KNOWLEDGE MANAGEMENT DEVICE, KNOWLEDGE MANAGEMENT DEVICE TERMINAL DEVICE AND KNOWLEDGE MANAGEMENT DEVICE PROGRAM**

(30) Priority: 17.06.2013 JP 2013126237; 07.05.2014 JP 2014095626
(71) Applicant: Digital Collaborations Corporation, Nagoya-shi, Aichi 460-0014 (JP)
(72) Inventor: ISHII Tatsuhisa, Nagoya-shi Aichi 460-0014 (JP)
(74) Representative: TBK
(86) International application number: PCT/JP2014/065158
(87) International publication number: WO 2014/203755

(57) **Abstract**

Knowledge held by persons is accumulated by using a computer, and any person visually searches for the knowledge and utilizes a result of the search to continuously accumulate new knowledge, so that accurate, efficient work is implemented. Various types of knowledge are accumulated by describing knowledge held by persons in a coordinate system of 2D data or 3D data produced by digital techniques by using a method of a feature point representing a location of the knowledge by using a geometric shape or a position of a coordinate of the coordinate system.

## Description

### TECHNICAL FIELD

The present invention relates to a knowledge management device which manages knowledge of persons by using 2D data or 3D data generated by digital technologies.

### BACKGROUND ART

In recent years, in manufacturing industries of heavy industrial products, plants, ships, vehicles, electrical products, electronic products, and the like, the world is under the competition in quality assurance, low cost, reduction of lead time of development and production. In addition, in global product development, production, and service business, higher quality assurance and efficiency are further required in a company, in a company group, or between companies.

In addition, in recent years, in the medical field, due to employment of electronic medical charts for patients, medical examination results are shared by doctors within a hospital, or medical information is shared between remote areas, so that sophistication of the medical services has been promoted.

In terms of techniques, in manufacturing industries, a real product is laser-measured by 3D measurement instrument, and the measured data are displayed as 3D data display. In medical sites, as a technique of scanning an object by using radiation or the like, processing the data by using a computer, and configuring an inner image of the object, organ shape measurement technologies using medical instruments such as computed tomography (CT) or magnetic resonance imaging (MRI) have been commercialized.

In addition, in movies, comics, animation, games, advertisement, or the like, there are many works produced by computer graphics (CG) using a computer or other electronic devices.

In this manner, in the manufacturing industries, medical fields, movies, comics, animation, games, advertisement, and the like, due to the utilization of the 2D data or the 3D data, paper drawings, films, papers, pictures, and the like in the related art have been replaced. By the utilization of the 2D data or the 3D data, it can be easy to visually understand a transmitted purpose.

As specific merits of 3D data, for example, conveniently, a designer can visually express an accuracy of a real product by a 3D measurement instrument by using 3D data generated by a 3D CAD system and 3D data from measurement result data of the 3D measurement instrument.

In addition, the MRI has a merit in that, without an external scratch to a human body, a symptom as 3D data obtained from a shape of an inner hidden thing can be easy to specifically recognize.

In this manner, in the manufacturing industries, medical field, movies, comics, animation, games, advertisement, or the like, by using the 2D data or the 3D data, what is not seen can be allowed to be displayed to be easily understood and seem to exist, so that communication between persons can be more accurately and speedily performed than the words can.

Therefore, without knowing the language, understanding can be made with respect to a foreigner, and understanding in conversation between experts and persons who are not experts can be easily made.

Due to the utilization of the 2D data or the 3D data, the understanding of the object or product can be easily made by displaying document, figures, graphs, or virtualized things. However, conceptual contents such as background for understanding or thought are recorded in separate means such as paper, audio, and digital files.

For example, a person performs seeing and thinking the 3D data. In the manufacturing industries, in many cases, the thought result is written in a separate technical material, and in the medical field, the 3D data and the result written in the medical charts are separately stored.

Also in the movies, comics, animation, games, advertisement, or the like, in the production step thereof, the 2D data or the 3D data and the story are often separately recorded.

However, during the generation, technical materials, medical charts, or stories thereof associated with the 2D data and the 3D data used in the manufacturing industries, medical field, movies, comics, animation, games, advertisement, and the like have relationship with the 2D data or the 3D data and the technical materials, medical charts, and stories in the measurement step or the production step. Therefore, in the measurement step or the production step, if the 2D data or the 3D data are changed, the technical materials, the medical charts, or the stories are dependently changed.

In the manufacturing industries, in the case where, during the design, 3D data as a temporary blueprint are transferred to a supplier and the supplier determine whether or not to manufacture, every time when the design is changed, the examination as to whether or not to manufacture and the examination result materials are produced by handwriting, document producing software, or the like.

In the medical field, a change from a previous disease state to a current disease state is determined by comparing the 3D data of the MRI, and as a result, the medical chart is also described in accordance with the disease state.

In the fields of movies, comics, animation, games, advertisement, and the like, the 2D data or the 3D data in the production step are changed at the time amendment to the stories, and the inserted audio is also changed according to the change of the 2D data or the 3D data.

As described above, in the design, measurement, or production step using the 2D data or the 3D data, it is considered that, if things that persons think, diagnose, or imagine are sequentially recorded in association with the above-described 2D data or the 3D data, work efficiency is further improved. In addition, the accumulated knowledge can also be utilized as educational or teaching materials.

In the manufacturing industries, since the method of producing 2D drawings from 3D data and distributing to the supplier or the like takes much time and are a burden to the designer, some improvement is needed.

In recent years, due to the spread of 3D printers, products have been directly processed and manufactured from 3D data. In this method, although products are manufactured by using geometrical information of the 3D data, drawings like the related art are needed for instructions indicating what the purpose of design of the geometric shape is, what dimensional tolerance the products are processed at, or the like.

Although the 3D printers are speedy devices, it is difficult to speed up engineers' works.

In the future, when the utilization of the 3D printers are advanced, a method of accumulating intention, purpose, processing instructions, surface processes, paint instructions, or things that are determined from knowledge of manufacturing including materials and substance in the generation of the 3D data immediately during the generation of the 3D data is predicted to be required.

In the manufacturing industries, there is software of managing the 3D data, which is referred to as product lifecycle management (PLM).

However, the PLM is mainly to retain attributes of parts in units of part numbers. In the PLM, data in units of processing portions for manufacturing such as quality and accuracy for some portions of the shape of the part or production cost of some portions of the shape of the part cannot be treated.

In the market, there is also software referred to as "Knowledge System". However, in the software, in many cases, the management unit is a document unit. Therefore, a necessary document are searched for by inputting a plurality of keywords called tags of title name, production date, production department name, and producing person's name of the document to be displayed to the user. However, since the software is operated in units of a document, there is a problem in that necessary knowledge such as relationship of the knowledge cannot be speedily recognized. In addition, classification cannot be performed in units of knowledge, and systematical understanding is difficult. If a purpose, means, a reason for selecting the means, or the like is intended to be known, many documents needs to be searched and read. In addition, there is a problem in that it is not known whether or not there are sufficient descriptions therein.

Since a check list of design review of a 3D CAD model of a newly developed product or a model-changed product is generated from documents such as previous trouble collections, specifications for design and production by posting with hand, much time is taken, the accuracy is not sufficient, and maintenance of the check list is not continuously performed. Therefore, technical determinations such as identification of problems of design review in the product development step are different among persons, and thus, in many case, product design is also reworked.

Technical comparison of products by examining documents such as previous drawings or reports is performed at each necessary time. However, since the personnel who are in charge of the comparison may be changed due to personnel transfers, items of the technical comparison are not uniform but fragmentary. Therefore, a difference is likely to exist between the technique comparison and the determination. In addition, all the techniques that have been advanced are not acquired.

In the manufacturing industries, as a knowledge system, there is a system of imaging actual scenes of the processes as video. However, in this system, although visual understanding can be made, the reason why the method is employed needs to be added by using an audio or a text. This is a time-consuming method and editing is not easy, which is a problem. In addition, since the method is not directed to the knowledge of the design such as design intentions of the product designer, there is a limitation in the knowledge which is to be accumulated.

Knowledge is increased by utilizing previous knowledge of many designers or experienced persons in the production side or systematically collecting the knowledge while newly acquiring understandings during the product development step, and the blueprint is generated by using the knowledge. During the natural organization activities, a method capable of accumulating and managing the knowledge is needed. In the method of going back in memory and organizing knowledge after the completion of the design, knowledge missing may occur due to depending on the memory, and timing missing may occur due to disband or the like of the product development team, so that there is a problem in that the knowledge is not fixed.

In the medical field, in many cases, the electronic medical charts obtained by doctor's medical examination are 2D data. For example, things observed and determined from the organ state expressed by the 3D data of the MRI are stored in the electronic medical charts which is a 2D medical examination result separated from the 3D data of the MRI.

Therefore, the doctor reading the electronic medical charts needs to display the MRI data again to superpose the displayed result with the electronic medical charts in mind. In many cases, the determination process is not described.

In the case where the patient changes the hospital, the electronic medical chart is transferred to the new hospital. However, in general, for medical examination, MRI measurement is performed on the diseased part again.

Since there is a possibility that the patient's disease is changed, MRI measurement is performed again. However, the previous measurement result cannot be compared, and thus, there is inconvenience in that both of the patient and the doctor performing diagnosis cannot use the previous medical examination result.

Since the doctor is also changed, diagnosis is performed based on experience of a new doctor. Therefore, it is important to efficiently share many previous cases, doctors' diagnosis results, or the like.

As described above, not only the manufacturing industries or the medical field, as the measures to the movement of the knowledge together with persons due to movement of personnel among departments or movement of personnel among companies during the activities of persons, knowledge accumulation techniques cannot be said to be sufficiently implemented.

Furthermore, it is not easy to find the 2D data or the 3D data of a product as an object or the 2D data or the 3D data from measurement data obtained by MRI or the like in the medical field based on understandings or knowledge perceived by persons. In many methods, the 2D data or the 3D data are searched for by a file name, a model name, or the like, and thus, these methods cannot reply to various search requests of the user.

In addition, as systems which manage knowledge in design, production, or the like, there are systems disclosed in, for example, Patent Documents 1, 2, 3, and 6. Patent Document 4 discloses a method of consecutively describing information on a sheet on a display. In addition, Patent Document 5 discloses a system which manages knowledge in the medical field.

### CITATION LIST

### PATENT DOCUMENTS

Patent Document 1: JP 2004-178170 A Patent Document 2: JP 7-93013 A
Patent Document 3: JP 2000-259664 A
Patent Document 4: JP 2003-225209 A
Patent Document 5: JP 2005-250807 A
Patent Document 6: JP 2013-97743 A

### DISCLOSURE OF THE INVENTION

### PROBLEM TO BE SOLVED BY THE INVENTION

However, Patent Document 1 discloses a method relating to a design manufacturing data management system and converting design data into input data described in a predetermined format. In particular, although the input data are converted into integrated data described in tagged language which can represent the data in a hierarchical structure to be stored and managed, Patent Document 1 does not consider a knowledge storage format.

Patent Document 2 relates to a CAD/CAM device capable of being automated without requiring manpower. Conditions represented by note/symbol data in product drawings are defined as attribute data, and the note/symbol data and figure data of figures in the product drawings are allowed to be associated with each other by using the attribute. Subsequently, the patent document discloses that processing conditions or processing shapes are automatically defined from the associated figure data and the note/symbol data. The patent document discloses a method of noting data delivery of the CAD and the CAM. However, the patent document is not intended to generally accumulate a wide range of the knowledge.

Patent Document 3 discloses a manufacturing technique information management database configuring method of forming a set of products having a set of use attributes that are attributes arbitrarily defined in advance as a product group and representing a product in the product group as a set of values of the use attributes. However, the knowledge such as relationship between design intention and a design structure or a reason for selecting the design structure and a processing method is not to be accumulated.

Patent Document 4 discloses a method where, in a system provided with a control/calculation device reflecting input information on a display, a belt-shaped sheet having an infinite length which is extended in a predetermined direction of a screen is displayed on the display, segment and stroke data representing boundary lines are sequentially input by a pen on the displayed belt-shaped sheet. However, the method is not a method using 3D data and is not sufficient as a visual method.

Patent Document 5 discloses a regional medical service/welfare cooperated network system for comprehensively supporting medical service and welfare of the entire region including remote areas. In addition, the patent document discloses a medical image display means, a report generation/transmission means, an interpretation supporting means, and the like for remote support by transmission and reception of electronic medical charts or MRI images or audio. However, the patent document does not disclose a method of implementing an electronic medical chart utilizing 3D data directly attached with a diagnosis result for the 3D data obtained from imaging results of MRI or the like.

Patent Document 6 discloses a device of systematically accumulating, transmitting, and utilizing knowledge on a 3D CAD model by designating a specified coordinate point in a coordinate system where a 3D CAD model is disposed and describing the knowledge held by persons in charge of works such as production and service from product design in the coordinate point. However, the patent document does not disclose a means of visually describing the knowledge about 3D data or 2D data except for the 3D CAD model and accumulating the knowledge.

The present invention is to improve efficiency of work by visually accumulating, transmitting, and utilizing knowledge held by people by using 2D data or 3D data and a knowledge describing means referred as a feature point.

### MEANS FOR SOLVING PROBLEM

According to a first aspect of the present invention, there is provided a knowledge management device managing knowledge by using 2D data, wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data, wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data, wherein, with respect to the following feature point, a coordinate of a point which a person designates in order to explain the knowledge in a coordinate system of 2D data is referred to as a feature point, and wherein the knowledge management device includes: a feature point describing means which describes the feature point for describing at least one or more pieces of knowledge about 2D data in the same coordinate system in a coordinate space for display of the 2D data; a knowledge describing means which describes the knowledge in the feature point; and a knowledge storing means which stores the knowledge and the 2D data in association with each other by affixing a unique feature point management number to the feature point.

According to a second aspect of the present invention, there is provided a knowledge management device managing knowledge by using 3D data, wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI, wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 3D data, wherein, with respect to the following feature point, a coordinate of a point which a person designates in order to explain the knowledge in a coordinate system of 3D data is referred to as a feature point, and wherein the knowledge management device includes: a feature point describing means which describes the feature point for describing at least one or more pieces of knowledge about 3D data in the same coordinate system in a coordinate space for display of the 3D data; a knowledge describing means which describes the knowledge in the feature point; and a knowledge storing means which stores the knowledge and the 3D data in association with each other by affixing a unique feature point management number to the feature point.

According to a third aspect of the present invention, there is provided the knowledge management device of the first aspect, further including: a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point); a knowledge describing means which describes the knowledge in the higher feature point; and a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number.

According to a fourth aspect of the present invention, there is provided the knowledge management device of any one of the first to third aspects, wherein 2D data or 3D data as an object of description of the feature point hereinafter are referred to as feature point described object data, and wherein the knowledge management device further includes: a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge; and a reference knowledge storing means which stores the reference relationship and the reference data.

According to a fifth aspect of the present invention, there is provided the knowledge management device of any one of the first to fourth aspects, further including a coordinate transformation feature point describing means which transforms at least two or more feature point described object data produced by different coordinate systems into a common coordinate system and describes the feature point.

According to a sixth aspect of the present invention, there is provided the knowledge management device of any one of the first to fifth aspects, further including a knowledge utilizing storing means which stores the feature point described object data and the knowledge for using the accumulated knowledge through the feature point management number and utilizes the knowledge.

According to a seventh aspect of the present invention, there is provided the knowledge management device of any one of the first to sixth aspects, further including: a knowledge classification affixing means of a classification name or the like of the knowledge; a knowledge registering means which describes the knowledge by selecting a word from a knowledge classification managing means; and a knowledge searching means which searches and displays the associated feature point described object data from knowledge classification or contents described as the knowledge;

According to an eighth aspect of the present invention, there is provided the knowledge management device of any one of the first to seventh aspects, further including a knowledge disclosure restricting means having a disclosure control means which performs space definition by using a coordinate of the feature point to disclose a portion of the feature point described object data or a portion of the knowledge to another person.

According to a ninth aspect of the present invention, there is provided a terminal for a knowledge management device managing knowledge by using 2D data or 3D data, wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data, wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI, wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data or 3D data, wherein, with respect to the following feature point, a coordinate of a point which a person designates in order to explain the knowledge in a coordinate system of 2D data or 3D data is referred to as a feature point, and wherein the knowledge management device includes: a feature point describing means which describes the feature point for describing at least one or more pieces of knowledge about 2D data in the same coordinate system in a coordinate space for display of the 2D data; a knowledge describing means which describes the knowledge in the feature point; a knowledge storing means which stores the knowledge and the 2D data in association with each other by affixing a unique feature point management number to the feature point; a feature point describing means which describes the feature point for describing at least one or more pieces of knowledge about 3D data in the same coordinate system in a coordinate space for display of the 3D data; a knowledge describing means which describes the knowledge in the feature point; a knowledge storing means which stores the knowledge and the 3D data in association with each other by affixing a unique feature point management number to the feature point; a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point); a knowledge describing means which describes the knowledge in the higher feature point; and a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number, wherein 2D data or 3D data as an object of description of the feature point hereinafter are referred to as feature point described object data, wherein the knowledge management device further includes: a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge; a reference knowledge storing means which stores the reference relationship and the reference data; a coordinate transformation feature point describing means which transforms at least two or more feature point described object data produced by different coordinate systems into a common coordinate system and describes the feature point; a knowledge utilizing storing means which stores the feature point described object data and the knowledge for using the accumulated knowledge through the feature point management number and utilizes the knowledge; a knowledge classification affixing means of a classification name or the like of the knowledge; a knowledge registering means which describes the knowledge by selecting a word from a knowledge classification managing means; a knowledge searching means which searches and displays the associated feature point described object data from knowledge classification or contents described as the knowledge; and a knowledge disclosure restricting means having a disclosure control means which performs space definition by using a coordinate of the feature point to disclose a portion of the feature point described object data or a portion of the knowledge to another person, and wherein the terminal includes a feature point input means; and a knowledge input means, and wherein information input from each means is transmitted from the terminal to the knowledge management device, the primary and higher feature point describing means, the knowledge describing means for the primary and higher feature points, the knowledge storing means for the knowledge described in the primary and higher feature points, the reference feature point knowledge describing means, the reference knowledge storing means, the coordinate transformation feature point describing means, the knowledge utilizing storing means, the knowledge classification affixing means, the knowledge registering means, the knowledge searching means, and the knowledge disclosure restricting means included in the knowledge management device perform processes described in the claims based on the transmitted information, the knowledge management device transmits results of the processes to the terminal, and the terminal displays the transmitted results.

According to a tenth aspect of the present invention, there is provided a program for a knowledge management device managing knowledge by using 2D data or 3D data, wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data, wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI, wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data or 3D data, wherein, with respect to the following feature point, a coordinate of a point which a person designates in order to explain the knowledge in a coordinate system of 2D data or 3D data is referred to as a feature point, and wherein the knowledge management device includes: a feature point describing means which describes the feature point for describing at least one or more pieces of knowledge about 2D data in the same coordinate system in a coordinate space for display of the 2D data; a knowledge describing means which describes the knowledge in the feature point; a knowledge storing means which stores the knowledge and the 2D data in association with each other by affixing a unique feature point management number to the feature point; a feature point describing means which describes the feature point for describing at least one or more pieces of knowledge about 3D data in the same coordinate system in a coordinate space for display of the 3D data; a knowledge describing means which describes the knowledge in the feature point; a knowledge storing means which stores the knowledge and the 3D data in association with each other by affixing a unique feature point management number to the feature point; a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point); a knowledge describing means which describes the knowledge in the higher feature point; and a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number, wherein 2D data or 3D data as an object of description of the feature point hereinafter are referred to as feature point described object data, wherein the knowledge management device further includes: a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge; a reference knowledge storing means which stores the reference relationship and the reference data; a coordinate transformation feature point describing means which transforms at least two or more feature point described object data produced by different coordinate systems into a common coordinate system and describes the feature point; a knowledge utilizing storing means which stores the feature point described object data and the knowledge for using the accumulated knowledge through the feature point management number and utilizes the knowledge; a knowledge classification affixing means of a classification name or the like of the knowledge; a knowledge registering means which describes the knowledge by selecting a word from a knowledge classification managing means; a knowledge searching means which searches and displays the associated feature point described object data from knowledge classification or contents described as the knowledge; and a knowledge disclosure restricting means having a disclosure control means which performs space definition by using a coordinate of the feature point to disclose a portion of the feature point described object data or a portion of the knowledge to another person, and wherein the program allows the terminal and a computer of the knowledge management device to function as the primary and higher feature point describing means, the knowledge describing means for the primary and higher feature points, the knowledge storing means for the knowledge described in the primary and higher feature points, the reference feature point knowledge describing means, the reference knowledge storing means, the coordinate transformation feature point describing means, the knowledge utilizing storing means, the knowledge classification affixing means, the knowledge registering means, the knowledge searching means, and the knowledge disclosure restricting means.

### EFFECT OF THE INVENTION

Knowledge held by persons and a position relationship in 2D data or 3D data are accumulated, so that a relationship between a concept of the knowledge and detailed portions of the 2D data or the 3D data can be accurately understood and integrally displayed. Due to clarification of the position of the knowledge by a feature point to the 2D data or the 3D data, the associated 2D data or 3D data can be searched for from the knowledge, so that it is possible to correctly understand what the knowledge is specifically associated with. In addition, with reference to previous knowledge, the knowledge can be speedily utilized for new design, production, and examination, and the 2D data or the 3D data and the knowledge are accumulated in associated with each other. Therefore, the knowledge about the 2D data or the 3D data changing in the design, production, and examination processes is inherited, so that the knowledge accumulation can be continuously performed. A task of matching things that are seen with things that are understood or a posting task can be eliminated.

### BRIEF DESCRIPTION OF DRAWINGS

Fig. 1 is a diagram illustrating utilization of a knowledge management device between companies according to an embodiment.
Fig. 2 is a diagram illustrating a hardware relationship of the knowledge management device according to the embodiment.
Fig. 3 is a diagram illustrating a relationship with another system connected to the knowledge management device according to the embodiment.
Fig. 4 is a configuration diagram illustrating functions processed by the knowledge management device according to the embodiment.
Fig. 5 is a table of an example of knowledge classification of the knowledge management device according to the embodiment.
Fig. 6 is a diagram illustrating a feature point of the knowledge management device according to the embodiment.
Fig. 7 is a diagram illustrating a relationship between a feature point management number and knowledge of the knowledge management device according to the embodiment.
Fig. 8 is a diagram illustrating a different example of description of the feature point and the knowledge of the knowledge management device according to the embodiment.
Fig. 9 is a diagram illustrating feature point demarcation of the knowledge management device according to the embodiment.
Fig. 10 is a diagram illustrating a registration screen of a word such as knowledge classification or feature point demarcation of the knowledge management device according to the embodiment.
Fig. 11 is a diagram illustrating a screen of feature point generation and knowledge input in a 3D coordinate space of the knowledge management device according to the embodiment.
Fig. 12 is a diagram illustrating an example of a screen of a knowledge input form of the knowledge management device according to the embodiment.
Fig. 13 is a diagram illustrating a screen of generating a feature point in a different coordinate system of the knowledge management device according to the embodiment.
Fig. 14 is a diagram illustrating a knowledge registration screen for feature point described object data generated from a different coordinate system of the knowledge management device according to the embodiment.
Fig. 15 is a diagram illustrating a structure of accumulation of feature point described object data and knowledge of the knowledge management device according to the embodiment.
Fig. 16 is a diagram illustrating a knowledge search screen of the knowledge management device according to the embodiment.
Fig. 17 is a diagram illustrating a knowledge utilization screen of the knowledge management device according to the embodiment.
Fig. 18 is a diagram illustrating an information disclosure registration screen of the knowledge management device according to the embodiment.
Fig. 19 is a diagram illustrating an example of a screen of feature point generation in a 2D coordinate space of the knowledge management device according to the embodiment.
Fig. 20 is a conceptual diagram illustrating a higher feature point of the knowledge management device according to the embodiment.
Fig. 21 is a diagram illustrating an example of a screen of higher feature point generation of the knowledge management device according to the embodiment.

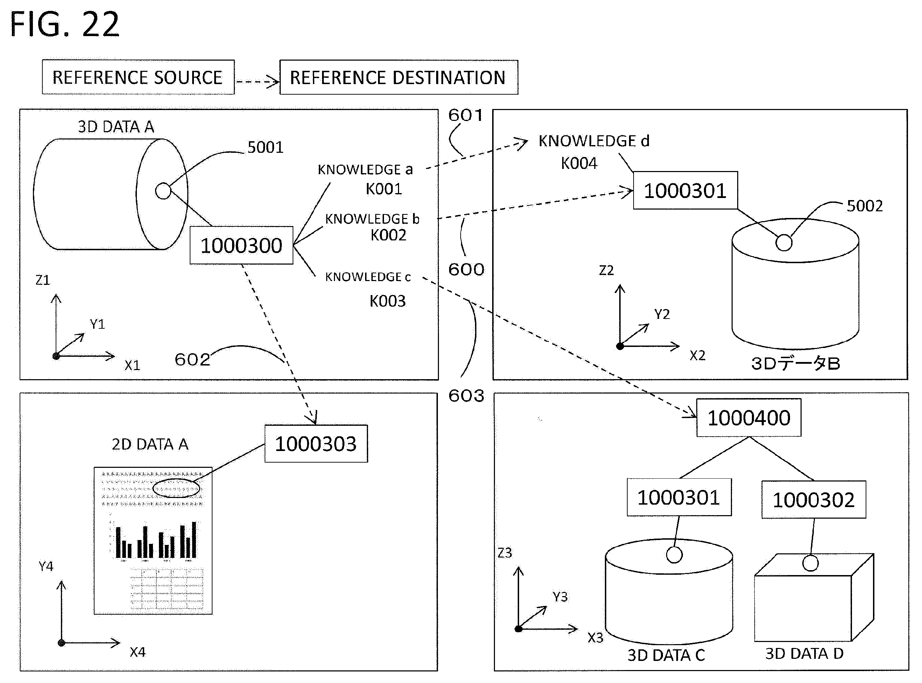

Fig. 22 is a diagram illustrating an example of reference relationship between a feature point and knowledge of knowledge management device according to the embodiment.
Fig. 23 is a diagram illustrating examples of transform of a plurality of feature point described object data into a common coordinate system in the knowledge management device according to the embodiment.

### MODE(S) FOR CARRYING OUT THE INVENTION

Hereinafter, embodiments of the invention will be described with reference to the drawings. In addition, in all figures, the same components are denoted by the same reference numerals, and the description thereof is appropriately omitted.

This embodiment is an example of a device managing knowledge by using 2D data or 3D data within a company. The company is arranged so as to be distributed to a plurality of bases in regions of which sites are different.

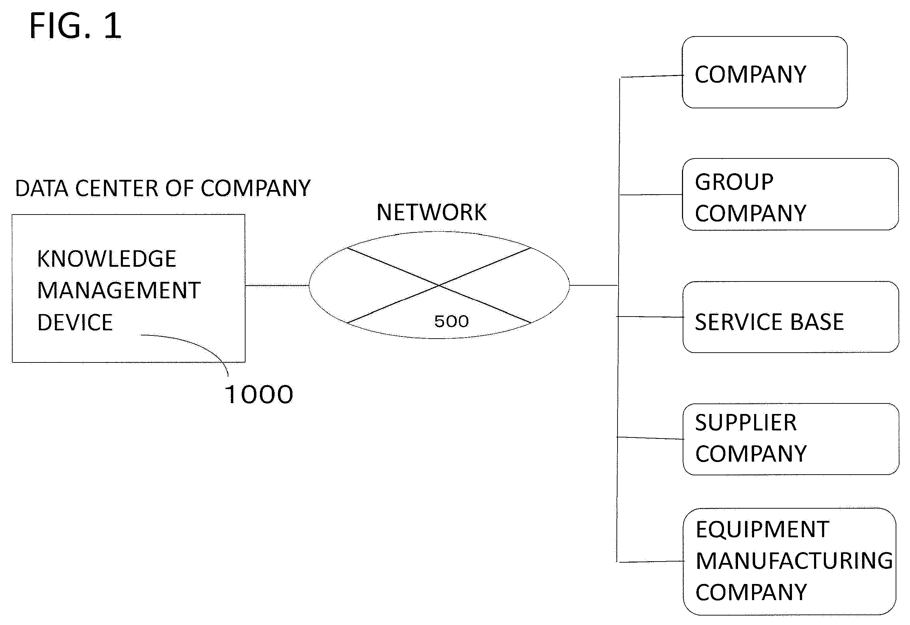

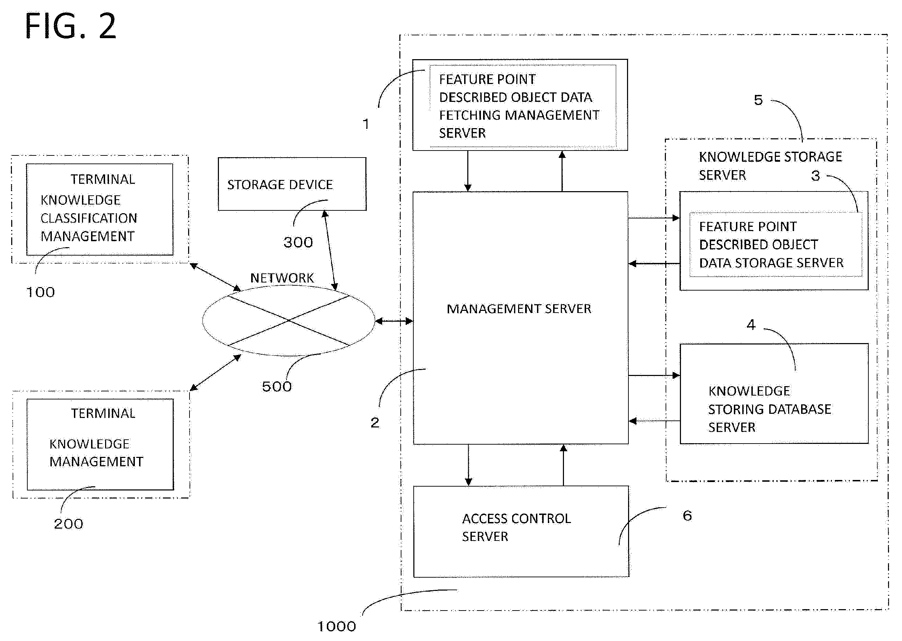

Fig. 1 illustrates connection between a knowledge management device 1000 according to the embodiment and companies, and Fig. 2 illustrates hardware of the knowledge management device 1000 and functions thereof. In Fig. 2, the knowledge management device 1000 is mainly configured to include a 3D data fetching management server 1 which acquires 3D data from an external storage device 300 and stores the data, a knowledge storage server 5 which stores knowledge, an access control server 6 which determines access permission of terminals 100 and 200 of a user to the knowledge management device 1000, and a management server 2 which manages the entire servers of the knowledge management device 1000.

The knowledge management device 1000 can be embodied as a hardware configured with general-purpose devices such as a central processing unit (CPU), a read only memory (ROM), a random access memory (RAM), and an interface (IF) unit to read a computer program and execute a corresponding data process, a dedicated logic circuit configured to execute a predetermined data process, a combination thereof, and the like.

A network 500 enables data communication by a cable such as an optical fiber or any means such as infrared rays and radio waves. In the example, the network is an intra-company local area network (LAN). However, for example, a wireless LAN, a wide area network (WAN), an intranet, or the Internet as a worldwide sized network configured by connecting a plurality of LANs or WANs may be employed.

In the embodiment, 2D data such as pictures, videos, and documents produced by Word, Excel, PowerPoint, or the like or 3D data such as measurement data obtained by 3D measurement instruments such as 3D CAD, 3D CG, MRI, or CT are transformed into a format available to the knowledge management device 1000, and the feature point described object data stored in a feature point described object data fetching storage unit 55 are used.

The format available to the knowledge management device 1000 is a format which can set a coordinate system for data and indicate an arbitrary coordinate point. For example, in the case of the 2D data, there is an image data format such as bitmap, compressed GIF, JPEG, or PNG; and in the case of the 3D data, there is a format for displaying and reading 3D data such as JT or Lattice XVL. In addition, the invention may be embodied as one of functions of application software treating 2D data which performs producing and editing documents of Word, Excel, or PowerPoint or pictures or application software treating 3D data which performs modeling, producing, and editing such as NX or CATIA.

The knowledge storage server 5 is configured with a feature point described object data storage server 3 and a knowledge storing database server 4. The feature point described object data storage server 3 stores geometric shape data of the feature point described object data. The knowledge data associated with the geometric shape data of one feature point described object data are stored in the knowledge storing database server 4. The feature point described object data and the knowledge are stored in the knowledge storage server 5 by associating a unique feature point management number with a key in the knowledge management device 1000.

On the other hand, through the Internet, the user performs knowledge accumulation or management by using the terminal 100 which performs the knowledge classification management of the knowledge management device 1000 or the terminal 200 which performs the knowledge management in Fig. 2. In addition, a company, a group company, a service base, a supplier company, and an equipment manufacturing company of the user include the storage device 300 outside the knowledge management device 1000 connected through the network 500.

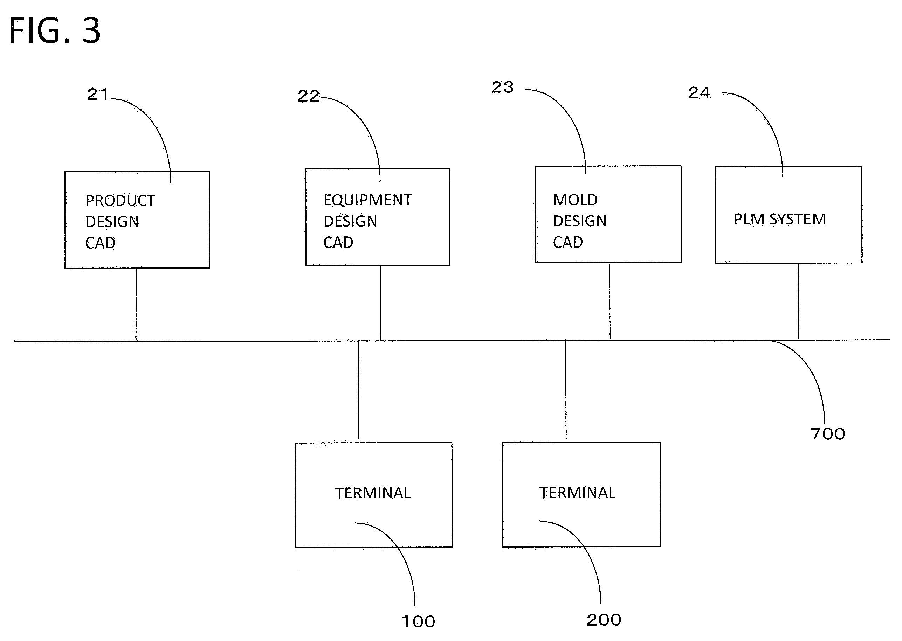

As illustrated in Fig. 3, the terminals 100 and 200 of the user are connected to a product design CAD 21, an equipment design CAD 22, a mold design CAD 23, and a PLM system 24 through an intra-company LAN 700. The intra-company LAN 700 is connected to the network 500 illustrated in Fig. 2 described above.

In Fig. 2, the storage device 300 is a storage device configured with a hard disk drive or the like which stores all of the feature point described object data produced and accumulated in the product design CAD 21, the equipment design CAD 22, the mold design CAD 23, and the PLM system 24 in units of a file. Herein, the format of the feature point described object data is output by the producing software and is stored in a state of a different format according to the software used for production.

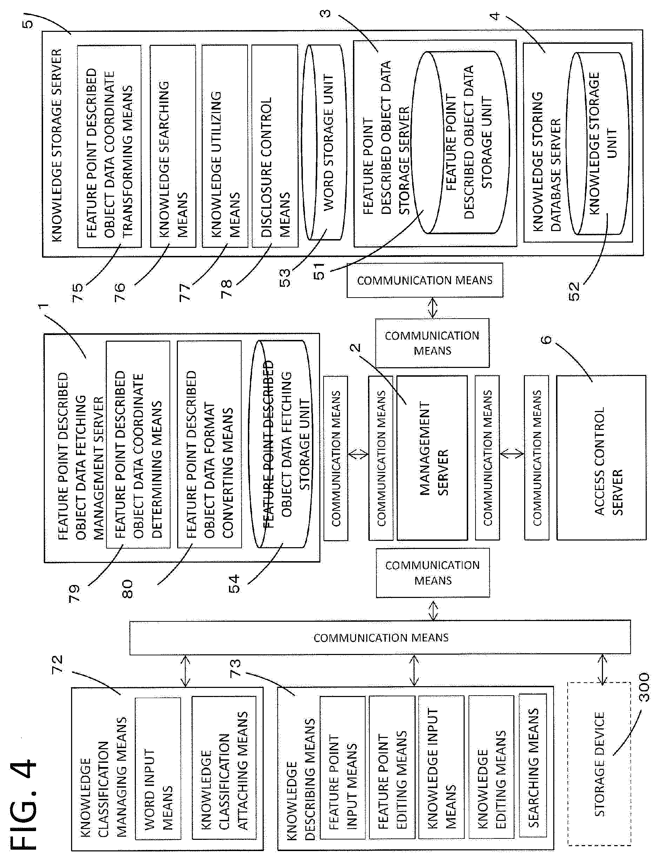

As the feature point described object data used by the knowledge management device 1000, the feature point described object data accumulated in the storage device 300 of Fig. 2 are used. Fig. 4 is a diagram illustrating functions of the entire system. Various types of the feature point described object data stored herein are transformed into a specific format in which the coordinate system where the feature point can be drawn can be set by the feature point described object data fetching management server 1, and the data are stored in a feature point described object data fetching storage unit 54 of the feature point described object data fetching management server 1.

In the case of the data for which it is difficult to set the coordinate system such as data produced by document producing software or spreadsheet software, for example, the software producing the data transforms a screen visually displayed on the terminal by using a screen capture function of the terminal into image data, and the image data may be fetched in the feature point described object data fetching management server 1. In addition, in the case of a video, images displayed in frames for a predetermined time interval are extracted, so that the image data are fetched in the feature point described object data fetching management server 1.

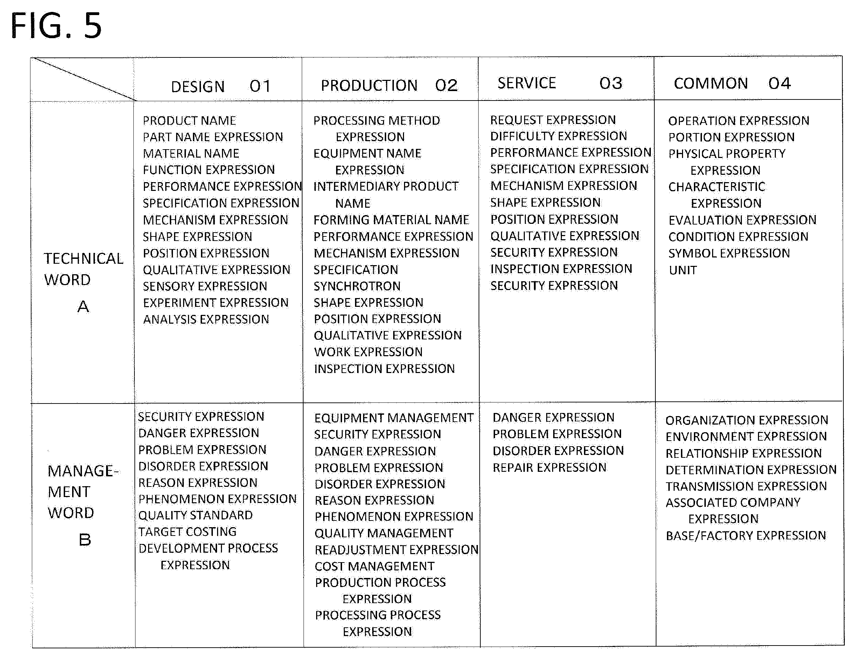

As illustrated in Fig. 5, in a knowledge classification managing means 72, with respect to words of technology and management, classification of word expressions of design, production, service, and common demarcation is defined. For example, in the classification of the word expression of product name as a technology word used for design, in the case of a car, words usable as a product name such as sport type, sedan, and truck are stored. This is because the knowledge is to be accumulated by using common words which can be understood as a unified meaning by the user in order to understand the knowledge. The function is included in a program of the terminal 100 for user registering in the knowledge management device 1000, and a master of words which is to be used for description of the knowledge is accumulated in a word storage unit 53 of the knowledge storage server 5 according to the user manipulation on the terminal 100.

A knowledge describing means 73 of Fig. 4 is included in the program of the terminal 200 of the user to perform processes of describing, searching, editing, copying, or the like of the knowledge actually according to the user manipulation on the terminal 200.

When the management server 2 receives a file call command for a specified feature point described object data from the terminal 200, the feature point described object data fetching management server 1 performs processes of requesting the storage device 300 to search for the file of the designated feature point described object data, fetching the file of the designated feature point described object data acquired from the search result of the storage device 300 in the feature point described object data fetching management server 1 to transform the data into a format of the feature point described object data designated by the terminal 200, determining a predetermined coordinate origin and x, y, and z axes as 3D coordinate axes by a transform program, and storing the data in the feature point described object data fetching storage unit 54.

The access control server 6 is a sever which controls transmission of the knowledge to the terminal 200 of the user by access authentication of the user to the knowledge management device 1000 or security authentication of the knowledge management device 1000.

The feature point described object data storage unit 51 of the knowledge storage server 5 is a site which stores the feature point described object data secured in the feature point described object data storage server 3. A knowledge storage unit 52 and a word storage unit 53 are included in the knowledge storing database server 4. The knowledge storage unit 52 is a site which stores standard input formats for describing the knowledge and the data input in the format. The word storage unit 53 is a site which stores knowledge classification or knowledge terminology of companies registered by the knowledge classification managing means 72 of the knowledge management device 1000.

The management server 2 serves as a central control function of the knowledge management device 1000. The management server 2 performs control of receiving information from the terminal 100 and the terminal 200, determining commands or information, and prompting the feature point described object data fetching management server 1, the knowledge storage server 5, or the access control server 6 to perform a process. On the contrary, the management server 2 performs control of receiving a process result from the feature point described object data fetching management server 1, the knowledge storage server 5, or the access control server 6 and transmitting the result information to an appropriate terminal.

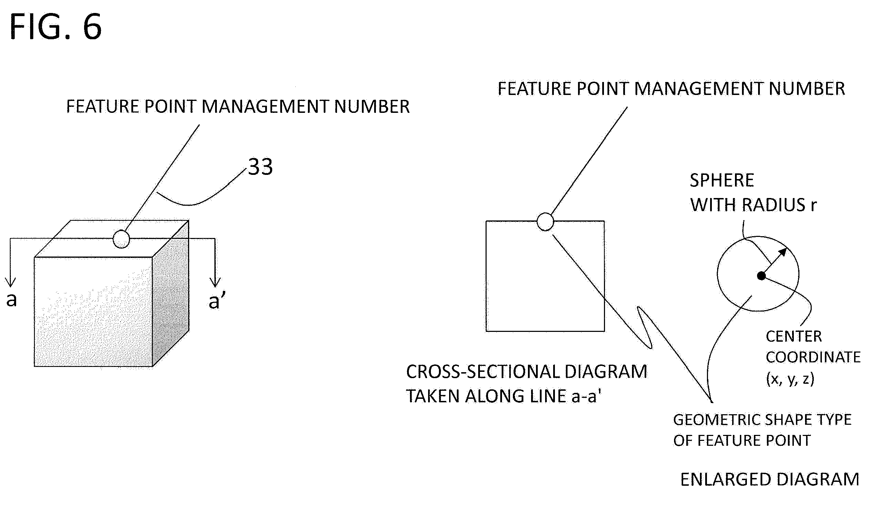

Fig. 6 illustrates an example of drawing a feature point of 3D data in a 3D coordinate space. The left figure illustrates a result of the drawing of the feature point on a surface of a rectangular parallelepiped. If the feature point is expressed by a coordinate (x, y, z) in the rectangular coordinate system, a person cannot easily perceive the feature point at the terminal 200 visually. Therefore, the feature point is formed, for example, in a sphere shape with a radius r centered at the coordinate (x, y, z) on the surface of the rectangular parallelepiped. Hereinafter, the shape for clearly displaying the feature point in this manner is referred to as a geometric shape type of the feature point. In addition, hereinafter, 33 is referred to as a lead line of the feature point.

Since the 2D data can be expressed by planar data including only the components of, for example, the x and y axes as the two axes in the rectangular coordinate system for the 3D coordinate space, the drawing of the feature point to the 2D data in the 3D coordinate space can be performed in the same method as above. Alternatively, the 2D data may be displayed in the 3D coordinate space by a process of designating an arbitrary plane in the 3D coordinate space and transferring information on the coordinate points included in the 2D data to coordinate points on the designated plane.

The drawing of the feature point to the 2D data in a 2D coordinate space may be performed in the same manner by designating a coordinate (x, y) of the rectangular coordinate system of the 2D space as the coordinate of the feature point and drawing a circle having a radius r as a geometric shape type centered at the coordinate.

The drawing of the feature point to the 3D data in the 2D coordinate space may be performed in the same manner as the drawing of the feature point to the 2D data in the 2D coordinate space, for example, by storing a cross-sectional diagram taken along the plane a-a' of the 3D data shown in the left figure of Fig. 6 as the 2D data and displaying the data in the 2D coordinate system.

In addition, the drawing of the feature point to the 3D data in the 2D coordinate space may be performed in the same manner as the drawing of the feature point to the 2D data in the 2D coordinate space by displaying the 3D data by using software of two-dimensionally visually displaying, storing the 2D data obtained by using such a method of capturing a state displayed on the screen with a screen shot, and displaying the image in the 2D coordinate system.

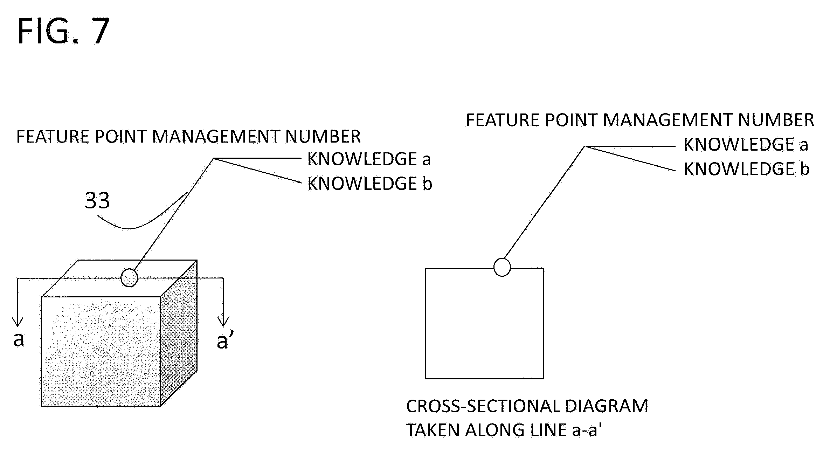

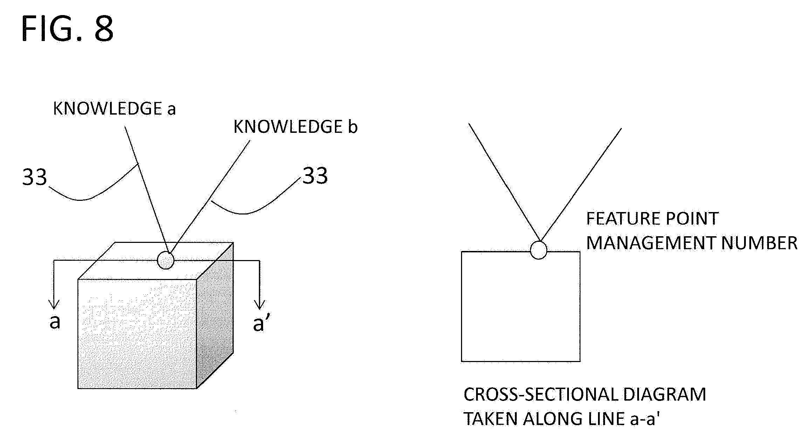

As an expression method at the time of generating a feature point at the same position and describing knowledge from different points of view about the feature point, as illustrated in Fig. 7, there may be used a method of setting the feature point as a common point and displaying a plurality of pieces of knowledge of knowledge a and knowledge b to one lead line 33; or as illustrated in Fig. 8, there may be used a method of setting the feature point as a common point and displaying knowledge a and knowledge b by using a plurality of lead lines 33. In the case where knowledge is described at many feature points, the method of Fig. 7 provides less complexity and allows the feature point management number to be easily viewed. Therefore, in the description hereinafter, the method of Fig. 7 is used.

When the position indicated by the generated feature point is viewed, in the case where the feature point described object data are 3D data, it is difficult to determine whether the feature point is on a configuration plane of a geometric shape of the 3D data, whether the feature point is an inner point of the geometric shape of the 3D data, or whether the feature point is in an outer space of the geometric shape of the 3D data; and in the case where the feature point described object data are 2D data, it is difficult to determine whether the feature point is on a line of 2D data, whether the feature point is a point on a plane of the 2D data, or whether the feature point is in a space except for the plane of the 2D data. Furthermore, in order to dispose the coordinate of the feature point on the plane or line of the geometric shape, the coordinate on the plane or line may be accurately designated by user manipulation with a pointing device. However, since this method causes the user manipulation to be complicated, the user defines and registers feature point demarcation to express the description of the object of the feature point considered by a person as words.

Alternatively, there may be used a method of obtaining the coordinate on the plane or line of the geometric shape by a calculation process and matching the feature point coordinate with the above coordinate by calculation. However, since there are many pieces of knowledge such as materials irrelevant to the geometric shape, words of expressing demarcation appropriate for the necessity of the user are defined as the feature point demarcation to increase a degree of freedom, so that a wide range of knowledge can be described.

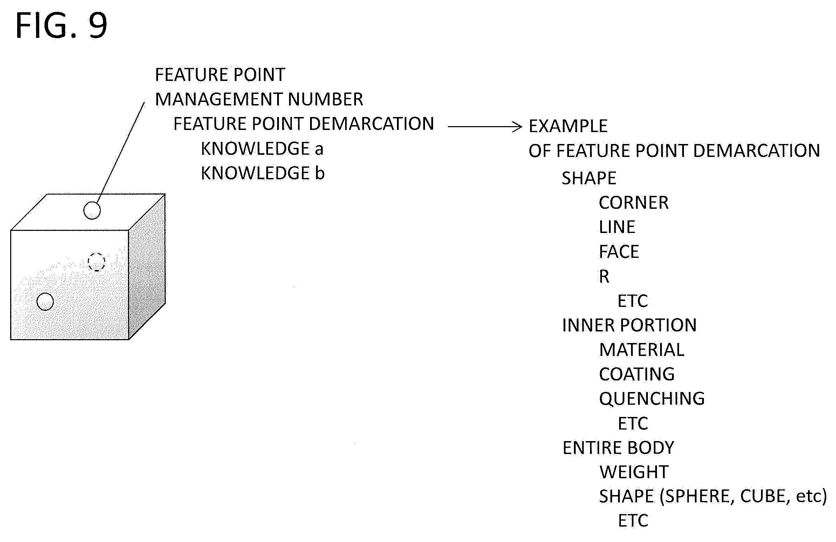

For example, as illustrated in Fig. 9, the feature point demarcation enables registration of the knowledge irrelevant to the geometric shape such as knowledge about internal materials or knowledge about total weight besides the registration of the shape.

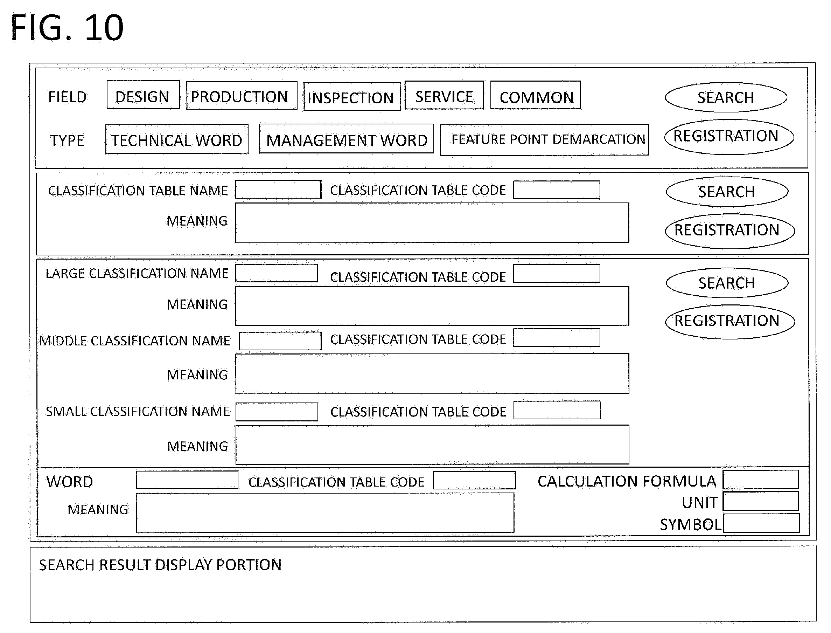

For example, definition of the words of the feature point demarcation displays Fig. 10 on the terminal 100 by a program of the knowledge classification managing means 72 according to user manipulation on the terminal 100. The input data of the designation of the feature point demarcation classified in Fig. 10 by the user and meanings of names and words are transmitted from the terminal 100 through the network 500 to the management server 2. The management server 2 transmits the information to the knowledge storage server 5 and instructs the knowledge storage server 5 to perform a process.

The knowledge storage server 5 searches for the word of the feature point demarcation existing in the word storage unit 53, and in the case where the same word exists or a similar word exists, the knowledge storage server 5 transmits the message to the management server 2. The terminal 100 receives the message, and the program of the knowledge classification managing means 72 displays the message on the display screen of the terminal 100 to prompt the user to make a determination.

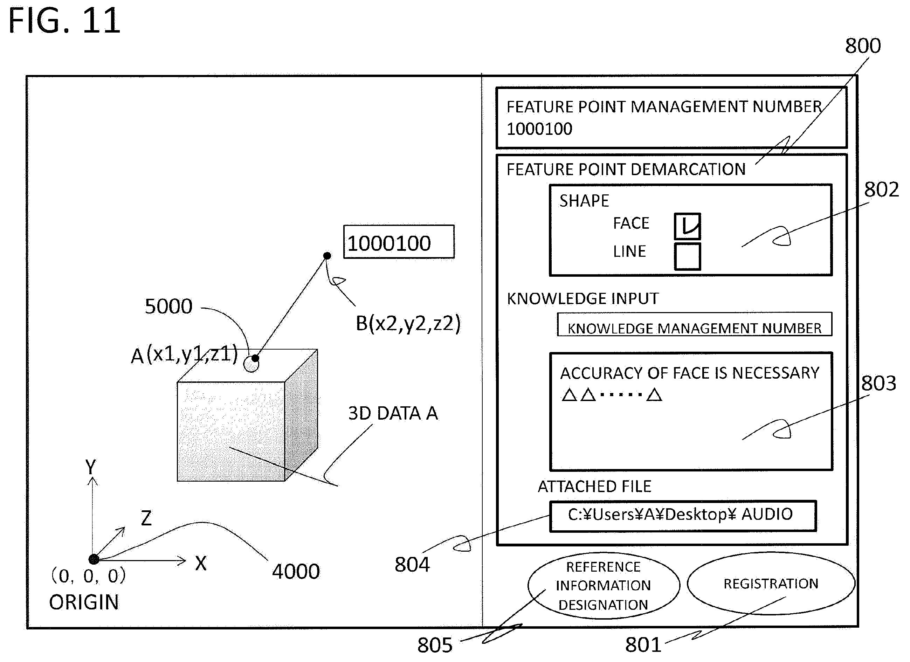

In the case where the word of the feature point demarcation does not exist in the word storage unit 53, the knowledge storage server 5 adds a new word as the word of the feature point demarcation to the word storage unit 53. The added word is displayed as a selection item of a feature point demarcation 800 of Fig. 11 which is a screen for generation of the feature point.

In the case where the feature point described object data are a measurement result of the 3D measurement instrument, the feature point described object data become point group data. With respect to the point group data in the space, since the feature point is one point, the feature point is arbitrarily generated in the coordinate system for the point group data, and the meaning of the feature point is selected through the feature point demarcation.

In this manner, the feature point demarcation is made of words different according to products of the companies, and within a company, the feature point demarcation functions as organizing the classification of the knowledge to be easily understood by the feature point demarcation and the coordinate location of the feature point of the feature point described object data.

Fig. 11 illustrates an example of a screen of generating a feature point 5000 to 3D data A as the feature point described object data in the 3D coordinate space. The user designates a feature point A indicating knowledge which the user desires to record by a pointing device such as a mouse or key manipulation on the 3D data A displayed on the screen. The designated coordinate (x1, y1, z1) is generated in the same coordinate system of the 3D data A having a coordinate origin 4000. In this case, the 3D data A are a surface model. In the case of recording the knowledge by allowing the feature point to denote the surface, there may be used a method of obtaining the feature point coordinate (x1, y1, z1) by calculation in a calculation process of finding the coordinate as the center of the sphere of the geometric shape type of the feature point within the surface. Alternatively, there may be used a method of determining the feature point at the coordinate designated by the pointing device or key manipulation of the user and clarifying the meaning of the target portion indicating the knowledge, for example, as a plane by using only the feature point demarcation.

In the case of generating the feature point to the 2D data as the feature point described object data in the 3D coordinate space, the 2D data extracted from the storage device 300 by manipulation on the terminal 200 may be transmitted through the management server 2 to the feature point described object data fetching management server 1, and the feature point described object data format converting means 80 of the feature point described object data fetching management server 1 may convert the data into a data format which can set a specified coordinate system treatable in the knowledge management device 1000. Alternatively, the 2D data may be displayed on the display screen of the terminal 200 by software of generating the 2D data by manipulation on the terminal 200, the displayed screen may be captured by the screen capture function of the terminal 200 to be stored as image data treatable in the knowledge management device 1000, and the image data may be transmitted to the feature point described object data fetching management server 1.

The feature point described object data fetching management server 1 determines the 3D coordinate system and the coordinate origin for the received 2D data by using the feature point described object data coordinate determining means 79 and stores the data in the feature point described object data fetching storage unit 54 of the feature point described object data fetching management server 1, so that the 2D data become treatable in the 3D coordinate space. Accordingly, by the above-described methods, the feature point to the 2D data can be generated in the 3D coordinate space.

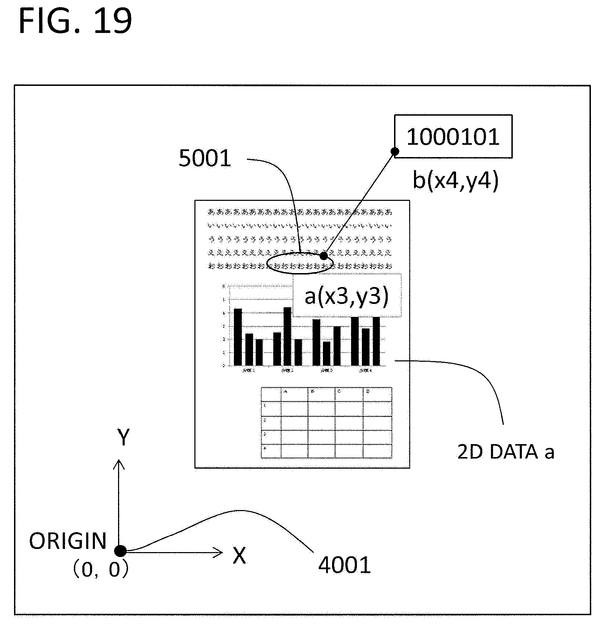

Fig. 19 illustrates an example of a screen of generating a feature point 5001 to 2D data as the feature point described object data in the 2D coordinate space. The user designates a feature point a indicating an object of knowledge of the user by a pointing device such as a mouse or key manipulation on the 2D data a displayed on the screen. The designated coordinate a (x3, y3) is generated in the same coordinate system of the 2D data a having a coordinate origin 4001.

At this time, for example, in the case of recording the knowledge where the feature point is allowed to denote the line, similarly to the example of generating the feature point to the 3D data in the 3D coordinate space, there may be used a method of obtaining a coordinate point on the line in a calculation process. Alternatively, there may be used a method of clarifying the line by the feature point demarcation.

In the case of generating the feature point to the 3D data as the feature point described object data in the 2D coordinate space, as the method of converting the 3D data extracted from the storage device 300 into the uniform 2D data treatable in the knowledge management device 1000 by manipulation on the terminal 200, there may be used a method of cutting the 3D data at a specified plane according to the user's designation on the software of generating the 3D data by manipulation on the terminal 200 by a calculation process, transforming the coordinate on the cut plane into the 2D coordinate system, and converting the transformed data into a specified 2D data treatable in the knowledge management device 1000 by the feature point described object data format converting means 80 of the feature point described object data fetching management server 1. Alternatively, there may be used a method of visually displaying the 3D data on the display screen of the terminal 200 in the software of generating the 3D data and storing the displayed screen as image data treatable in the knowledge management device 1000 by using the screen capture function of the terminal 200.

In this manner, the 3D data are converted into the 2D data treatable in the knowledge management device 1000, so that the feature point can be generated to the 2D data in the 2D coordinate space by the above-described methods.

Hereinafter, an example of a method of drawing the feature point 5000 corresponding to the 3D data A in the 3D coordinate space will be described.

After the feature point 5000 is determined, a lead line of the feature point as a segment led out from the feature point 5000 is drawn by user manipulation on the terminal. In this manner, according to the coordinate determination for another end point corresponding to the feature point, by a program of the knowledge describing means 73, information such as line type and thickness of the segment of the lead line of the feature point stored in the knowledge storage unit 52 in advance is called out from the knowledge storage unit 52, and the user is prompted to select the line type, thickness, and the like of the segment.

According to the selection result for the line type, thickness, or the like of the segment by the terminal 200 of the user, a program of the terminal 200 displays a feature line on the terminal 200 of the user.

At this time, the program of the terminal 200 displays a message of checking whether or not the user is to register the feature point A on the screen of the terminal 200, and by the user manipulation of the execution of registration, the information is transmitted from the terminal 200 of the user to the knowledge management device 1000 through the network 500. If the transmitted new feature point information is received in the knowledge management device 1000, the feature point management number 1000100 unique to the feature point A in the knowledge management device 1000 is determined based on a feature point management number rule unique in the regulated knowledge management device 1000 by a data management system installed in the knowledge storage server 5 in advance.

At this time, by the data management system of the knowledge management device 1000, the feature point management number 1000100 is newly registered also in the attribute of the 3D data A registered in the feature point described object data storage unit 51 of the knowledge storage server 5.

The feature point management number 1000100 stores, as the attribute, for example, a coordinate system where the feature point is generated, an A coordinate (x1, y1, z1) of the feature point and a B coordinate (x2, y2, z2) of another end point of the feature line, and date and time of generation of the feature point. After the knowledge storage server 5 completes the process, the determined feature point management number 1000100 is transmitted through the network to the terminal 200 of the user. The network interface of the terminal 200 of the user transfers the information to the program of the knowledge describing means 73 of the terminal 200 of the user. The program displays the feature point management number 1000100 to another end point B (hereinafter, referred to as a head of the feature point) of the feature line displayed by the user manipulation in the 3D data A where the information is displayed on the display screen of the terminal 200 of the user. By the process heretofore, the drawing of one feature point to the 3D data is completed.

The drawing is performed by executing the same process on the feature point generated in the feature point described object data in the 2D coordinate space.

Next, a process of grouping a plurality of the feature points and generating a higher feature point will be described.

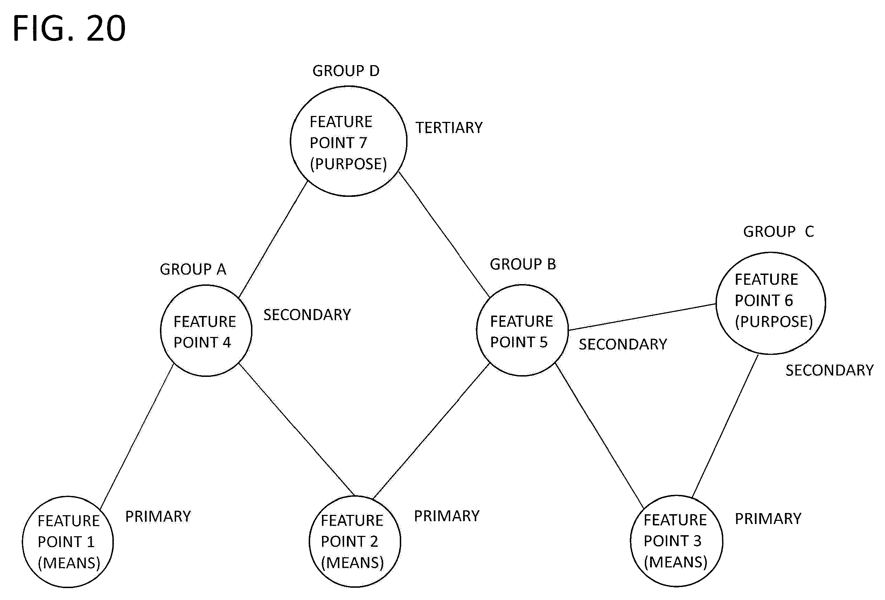

In Fig. 20, a feature point 4 indicates a secondary feature point as a group A of a feature point 1 and a feature point 2 which are primary feature points generated in the feature point described object data. Similarly, a feature point 5 indicates a new secondary feature point as a group B of the primary feature point 2 and a primary feature point 3. In addition, a feature point 6 indicates a secondary feature point as a group C obtained by grouping the primary feature point 3 and the secondary feature point 5. Furthermore, a feature point 7 indicates a new tertiary feature point 7 defined by grouping the secondary feature point 4 and the secondary feature point 5.

In the knowledge management device 1000, the primary feature points are stored in the feature point described object data. However, the primary feature points are components of the group of the secondary feature point, and in many cases, the primary feature points are relevant to other primary feature points. Therefore, by defining the secondary feature points as higher feature points, knowledge of relation of purpose and means is accumulated. Moreover, since there is also a need to describe knowledge associated with higher purpose, the higher feature point is defined by grouping arbitrary feature points, so that a structure capable of describing the knowledge associated with the higher purpose is implemented.

Therefore, for example, in the case of cost reduction, apart from a point of view of how to inexpensively implement the primary feature point designating a specified portion of the data, it may be considered whether or not there is a cheaper design structure while going back to the higher purpose. At this time, since the lower feature points constituting the higher feature point can be recognized at a time, it is possible to more speedily and accurately evaluate the cost, and it is possible to recognize conditions such as quality from the knowledge of other higher feature points having the lower feature points as components.

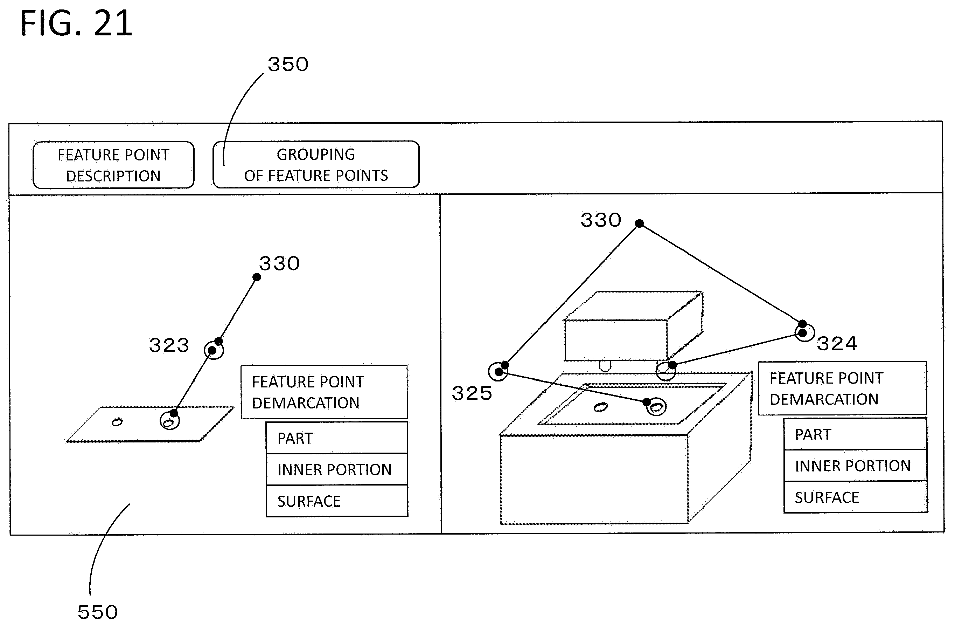

The details will be described with reference to Fig. 21 which is a feature point described object data display screen of the terminal 200 of the knowledge management device 1000. When the program of the knowledge management device 1000 is launched on the terminal 200, the program displays the screen of Fig. 21 on the terminal 200. By user manipulation, a mold designed to perform hole machining and a part produced by the mold are selected as the data displayed from the terminal 200, so that the search information is transmitted to the management server 2. The management server 2 transmits the search information to the feature point described object data storage server 3. The feature point described object data storage server 3 specifies the data of the mold and the part from the feature point described object data storage unit 51 according to the search information and transmits the data to the management server 2.

In the terminal 200, the data of the mold and the part, the feature point management numbers, and the arrows thereof are displayed on the terminal 200 by a process of the program of displaying the received data of the mold and the part, the feature point management numbers stored in the data, the geometric shape of the feature point, the coordinate of the head, the line type, and the like.

As a result, the data of the panel parts and the pressing mold are displayed on a feature point described object data display unit 550 of Fig. 21. In the terminal 200, the user designates feature point management numbers 324 and 325 of the data of the mold affixed as a result of description of the feature points of a punch opening a press hole and die parts and a feature point management number 323 affixed to the holes as the feature point of the part panel by using a pointing device such as a mouse and pushes a feature point grouping button 350 of Fig. 21 for associating the hole of the product with the machining means. When the process information is transmitted from the terminal 200 to the management server 2, the management server 2 transmits information on the grouping process to the knowledge storage server 5.

In the knowledge storage server 5, a feature point order determination program is operated, and the order of the feature point is determined by the following process logic. First, the feature point described in the data is set to order 1. With respect to the feature point obtained by grouping one or more feature points, an order obtained by adding 1 to the lowest order of the feature points constituting the group is defined as an order of the grouped feature point. If all the orders of the feature points constituting the group are the same order N, the order of the feature point is determined by the order determination program of setting N + 1 obtained by adding 1 to the order as the order of the higher feature point. In the case of the mold, since it is recognized to be configured with all the primary feature points based on the information from the terminal 200, the grouped feature point is determined to be a secondary feature point.

As a result, a secondary feature point management number is newly determined, with respect to each of the feature point management numbers 324 and 325 for the punch and the die and the feature point management number 323 for the part panel, in order to store the relation that the hole of the part panel indicated by the feature point 323 can be opened by the punch indicated by the feature point 324 and the die indicated by the feature point 325, the feature point management number 330 of the secondary feature point is registered. In addition, the feature point management numbers 323, 324, and 325 of the lower feature points are stored in the feature point management number 330 of the secondary feature point. The N-order feature point management number is processed and displayed in the same manner.

At this time, the higher feature point is drawn in the coordinate space of the data of the mold and the part. The coordinate of the higher feature point is set to the coordinate of the head of the lower feature point, and with respect to the coordinate of the head of the higher feature point, the user may determine the coordinate of the head of the higher feature point in grouping of the feature points by a method of designating arbitrary coordinates of the data of the mold and the part in the coordinate space. Alternatively, a method of automatically determining the coordinate based on a rule of offsetting a specified distance from a default coordinate by a calculation process may be used. The drawing process for the higher feature point after the determining process of the coordinate of the higher feature point and the coordinate of the head of the higher feature point is performed in the same manner as that of the process of the case of the primary feature point.

Next, an embodiment of describing knowledge about the feature point 5000 generated in the 3D data A as a target will be described with reference to Fig. 11.

In order for the user to register the knowledge about the feature point 5000 generated in the 3D data A as a target, the user designates the end point B of the feature line which is the head of the feature point of the feature point 5000 by using a pointing device. By the designation action, a knowledge input form 800 registered in advance in the knowledge management device 1000 for the registering knowledge is displayed on the screen of the terminal 200 of the user. When the user inputs the data in the knowledge input form 800 and pushes the registration button 801, the information on the knowledge is transmitted from the terminal 200 of the user through the network 500 to the knowledge storage server 5. When receiving the information, the knowledge storage server 5 recognizes a feature point management number 1000100 in the received information and stores the received information of the knowledge input form 800 in the knowledge storage unit 52 of the knowledge storage server 5 by using the feature point management number 1000100 as a key.

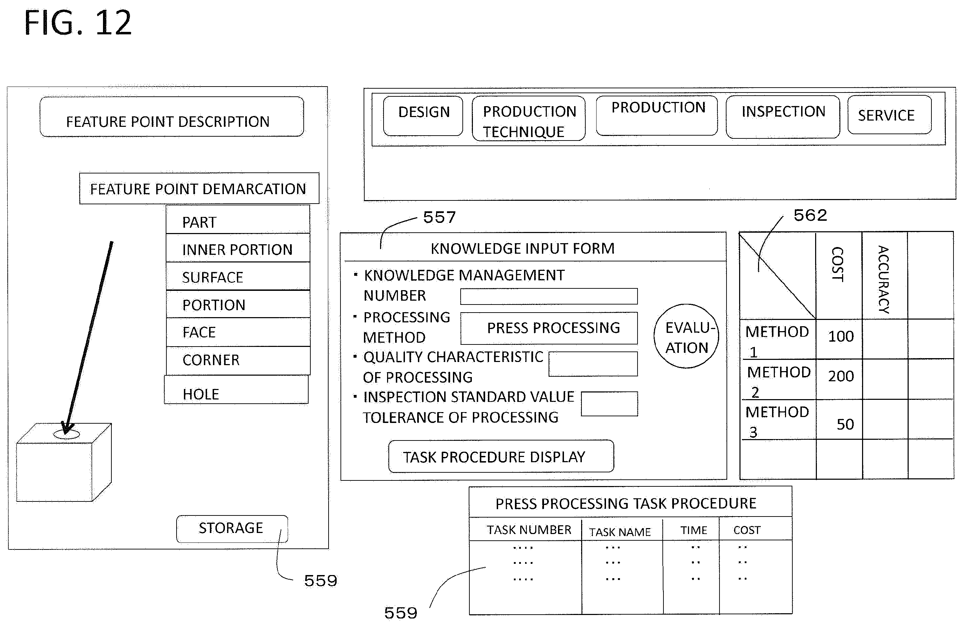

As illustrated in 557 of Fig. 12, in another example of the knowledge input form 800, by using the words such as a processing method, quality characteristics of processing, and an inspection standard tolerance of processing stored in the word storage unit 53 by the knowledge classification managing means 72 of the terminal 100, the knowledge describing means 73 generates a knowledge input form 557 and stores the knowledge input form in the knowledge storage unit 52. According to a display request of the knowledge input form 557 from the terminal 200 of the user, the management server 2 receives the requested knowledge input form 557 from the knowledge storage server 5 and transmits the knowledge input form to the terminal 200, and thus, the program of the terminal 200 displays the requested knowledge input form 557 on the terminal 200 of the user.

In the case of a text, as illustrated in the feature point demarcation 802 of the knowledge input form 800 of Fig. 11, for example, with respect to a plane or line as an item name about a shape, a method of selecting from words defined in advance as a master by the knowledge classification managing means 72 of Fig. 4 may be used, or as illustrated in a knowledge input column 803 of Fig. 11, a method of freely inputting sentence may be used. In any method, the knowledge registered from the terminal 200 is stored in the knowledge storage server 5 as an attribute having the feature point management number as a key.

In the case of an audio or video file, as illustrated in an attached file column 804 of Fig. 11, an actual audio or video file is designated by designating a local file of the terminal 200 or a directory of a file stored in the storage device 300 connected to the terminal 200 through the network 700 in Fig. 3 to the network 500, and the user of the terminal 200 pushes the registration 801 which is the registration button, so that the directory and the name of the designated audio or video file are transmitted through the network 500 to the management server 2, and the information is stored as data having the feature point management number as a key in the knowledge storing database server 4.

In the same process, a table, graph, or figure file or related 3D data are also stored as attribute data having the feature point management number 1000100 as a key in the knowledge storing database server 4.

In the case where a time code or a counter value representing a time point or time steps such as one-minute interval in an audio or video itself is buried in an audio or video file, the time code or the counter value of an audio or video of only the portion associated with the knowledge is also designated from the terminal 200 by user manipulation, and by pushing the registration 801, the time code or the counter value is stored in the knowledge storing database server 4.

Therefore, the knowledge of the audio or video can be indicated as the coordinate location in the 3D data coordinate system. For example, audios of results obtained by analyzing collision sound at the feature point 5000 are accumulated as the knowledge of the feature point management number 1000100, an actual collision sound is recorded in association with the feature point 5000 which is the audio occurring site of the 3D data, and knowledge recognized from the fact is described at the feature point 5000 in the knowledge input column 803 of Fig. 11, so that causes or the like of the occurrence of the collision sound can be shared by the user using the knowledge management device 1000.

In this manner, the user can simultaneously recognize both of the fact data and the opinion as to what kind of audio occurs from the site and position of the product and what is the reason thereof, so that the technical determination of the user can be performed speedily. During the production of movies, animations, or advertisement, this can be utilized for attaching dialog to the product obtained by generating a wide-range scenario with 3D data and reviewing during the production. In addition, this can be utilized as educational or teaching materials.

With respect to the knowledge of the characters, numbers, files of audios or videos, files of tables, graphs, or figures described in sentences or standard input formats or the associated 3D data, only one piece of knowledge is not registered for the one feature point 5000, but a plurality of different-type pieces of knowledge of text, audio file, video file, table, figure, 3D data file, and the like are registered, for example, as knowledge a and knowledge b illustrated in Fig. 7.

The time point of the computer of the terminal 200 at the timing when the user pushes the registration 801 which is the registration button of the terminal 200 is stored in the knowledge in the knowledge storing database server 4 for every knowledge.

Therefore, in the knowledge management device 1000, the same time point or the knowledge between some time points can be collected by using the time point as a search item. The previous knowledge and the current knowledge can be compared.

In this manner, with respect to the knowledge, besides the characters or the numbers described in the sentence or the standard input format in terms of expression format, the knowledge expressed as digital information such as the files of the audios or videos, the files of tables, graphs, or figures, the associated 3D data, or the like is accumulated in the knowledge storage server 5, and if the user's display request is executed in the terminal 200, similarly, the knowledge describing means 73 displays the digital information of the requested files of the audios or videos, files of tables, graphs, or figures, the associated 3D data, or the like on the terminal 200 of the user by the software installed in the terminal 200 which displays the data.

As attachments, for example, cross-sectional imaging views measured in the CT or MRI in the medical field or cross-sectional views of 3D data of designed parts in the manufacturing industries are accumulated.

When the feature point or the knowledge is to be described in the feature point described object data, the reference information designation button 805 of the knowledge input form 800 of Fig. 11 is pushed, and as supplement or reference data of the described feature point or the knowledge, the feature point generated in the feature point described object data or the knowledge described at the feature point is designated, so that the reference relationship between the feature point and the knowledge may be recorded.

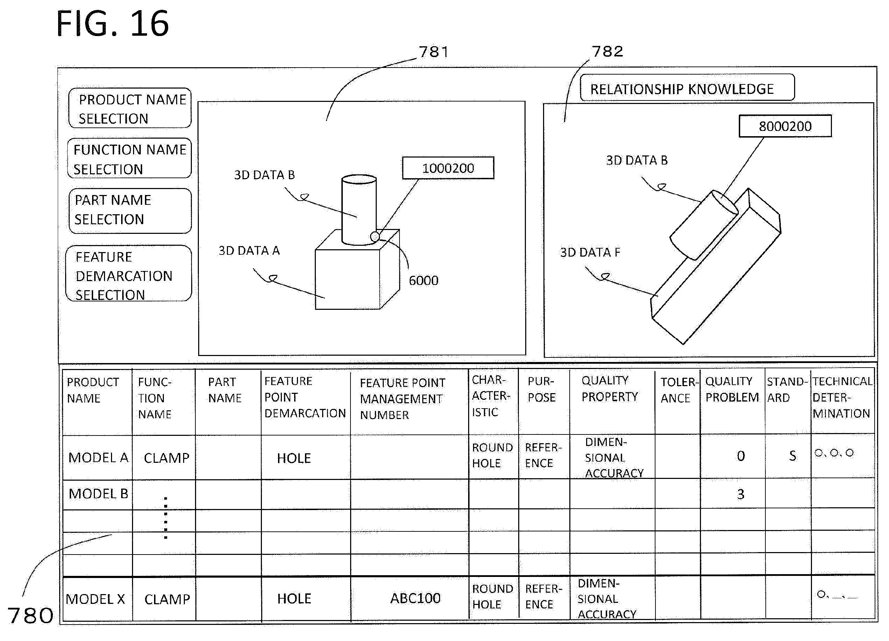

For example, when describing the knowledge at the feature point 5000 of the 3D data A of Fig. 11, the user transmits a search command for the feature point described object data, the feature point, or the knowledge to the knowledge management device 1000 by using the searching means of the terminal 200 and executes the knowledge searching means 76 of the knowledge storage server 5 to extract the feature point described object data from the feature point described object data storage unit 51 and to extract the feature point or the knowledge from the knowledge storage unit 52 and displays the feature point described object data, the feature point, or the knowledge on the display screen of the terminal 200 (Fig. 16).

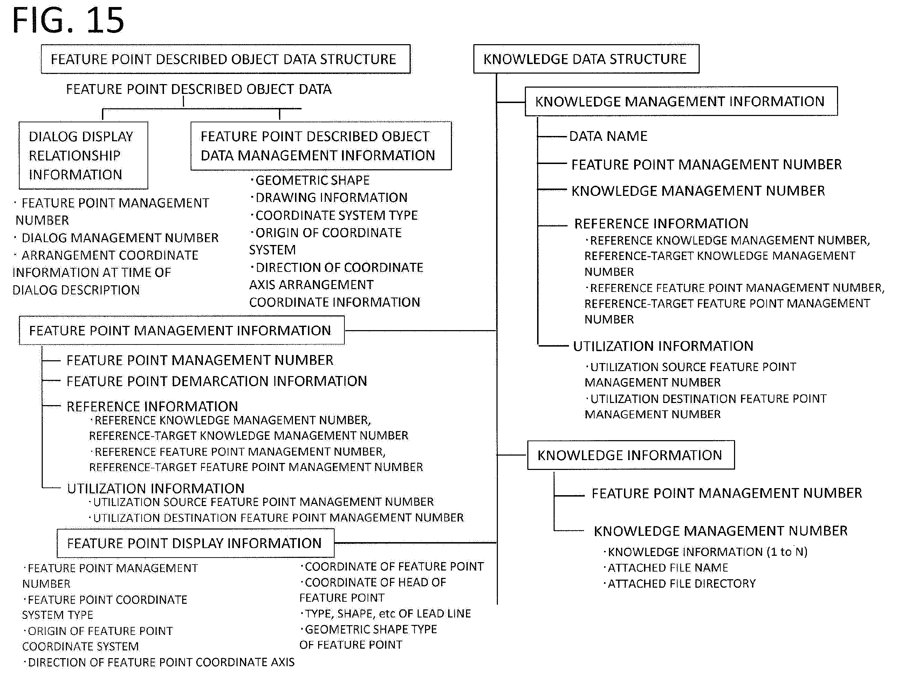

At the time of describing the feature point or the knowledge, when the user refers to the feature point or the knowledge of the feature point described object data displayed on the display screen of the terminal 200 by the above-described searching, the user pushes the reference information designation button 805 of the knowledge input form 800 to select the feature point or the knowledge. Alternatively, the user may generate new feature point or knowledge in the feature point described object data displayed on the display screen of the terminal 200 and may perform the selection. As illustrated in the data structure of the knowledge of Fig. 15, by the user manipulation of designation of the reference information, the feature point management number or the knowledge management number of the reference destination is stored in the knowledge management information of the knowledge of the reference source, the knowledge management number of the reference source is stored in the feature point management information of the feature point or the knowledge management information of the knowledge of the reference destination, and the reference relationship between the feature point and the knowledge is recorded.

At the time of describing the feature point or the knowledge, when the user refers to the feature point or the knowledge of the feature point described object data displayed on the display screen of the terminal 200 by the above-described searching, the user pushes the reference information designation button 805 of the knowledge input form 800 to select the feature point or the knowledge. Alternatively, the user may generate new feature point or knowledge in the feature point described object data displayed on the display screen of the terminal 200 and may perform the selection. As illustrated in the data structure of the knowledge of Fig. 15, by the user manipulation of designation of the reference information, the feature point management number or the knowledge management number of the reference destination is stored in the knowledge management information of the knowledge of the reference source, the knowledge management number of the reference source is stored in the feature point management information of the feature point or the knowledge management information of the knowledge of the reference destination, and the reference relationship between the feature point and the knowledge is recorded.

With respect to the reference relationship between the pieces of knowledge, similarly to the above-described reference relationship between the feature point and the knowledge, as indicated by a dashed arrow 601, when the knowledge a to the knowledge d are designated as the reference information, the knowledge management number K004 of the knowledge d is affixed as reference knowledge management number to the knowledge management information of the knowledge management number K001 of the knowledge a, and the knowledge management number K001 is affixed as reference-target knowledge management number to the knowledge management information of the knowledge management number K004, and the pieces of knowledge are stored in the knowledge storage unit 52, so that the reference relationship between the pieces of knowledge can be recorded.

In this manner, the reference relationship is recorded by using the knowledge management number and the feature point management number as keys, so that besides the reference relationship between the feature point and the knowledge described in the feature point described object data generated in the coordinate space of the same dimension, the reference relationship (dashed arrow 602) between the feature point and the knowledge described in the feature point described object data generated in the coordinate space of different dimensions, and the reference relationship (dashed arrow 603) between the feature point and the knowledge of which the orders are different can be recorded.

The designation of the reference information may be performed on the feature point or the knowledge which is already generated in the feature point described object data accumulated in the feature point described object data storage unit 51. Alternatively, the local file of the terminal 200 or the file of documents, tables, graphs, figures, images, videos, or 3D data stored in the terminals 21, 22, 23, and 24 connected to the terminal 200 and the network 700 of Fig. 3 may be designated to employ newly generated feature point or knowledge.

As a method of generating the feature point in the data of each terminal connected to the terminal 200 through the network 700, a plurality of virtual desktop environments are configured on the server by, for example, virtualization software, the data stored in the terminals 21, 22, 23, and 24 by using a virtual desktop technique of operating the desktop environments for the respective terminals on the server are expanded on the virtual desktops by executing applications corresponding to the data, and the data are displayed on the display screen of the terminal 200. The screen is fetched as the image data by a screen capture function or the like into the feature point described object data fetching management server 1, so that the feature point is generated.

The generation of the feature point for the image data is performed in the same manner as the generation of the feature point for the 2D data described above.

In this manner, the feature point is generated as the reference data in the data stored in an external storage device or an external terminal of the knowledge management device 1000, so that the data stored in the terminals 21, 22, 23, and 24 distributed within a company or the storage device 300 can be concentrated and accumulated in the feature point described object data storage unit 51 of the knowledge management device 1000 by designating the feature point as the reference data of the knowledge and using the feature point management number as a key.

In addition, the reference point is accumulated in the feature point and the knowledge of the data stored in the feature point described object data storage unit 51, so that the data, the feature point, or the knowledge of which the general-purpose and the degree of attention are high, from the height of the reference point can be preferentially searched for and displayed.

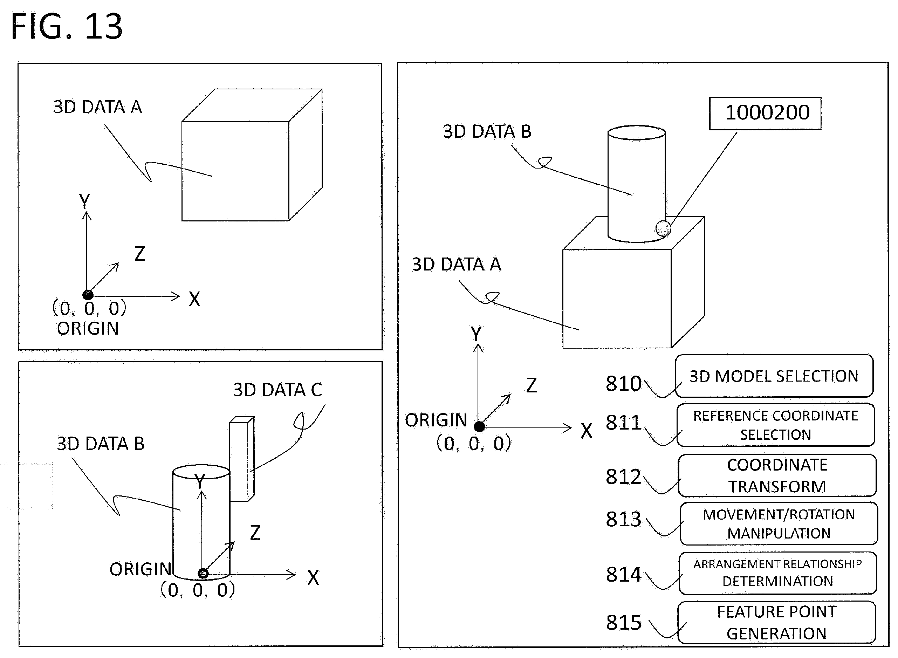

Fig. 13 illustrates the case of transforming the 3D data generated by different application systems into a common coordinate system and describing the feature point. First, the selection of the 3D data from the terminal 200 of the user is performed. The instruction information for the selection is transmitted from the terminal 200 through the network 500 to the management server 2.

The management server 2 determines that the information from the terminal 200 is information designating the file of the storage device 300 outside the feature point described object data fetching management server 1 of the knowledge management device 1000. The management server 2 commands the feature point described object data fetching management server 1 of the knowledge management device 1000 to operate the process of converting the file designated by the terminal 200 in the external storage device 300 into the uniform 3D data display format treatable in the knowledge management device 1000 and storing the data in the feature point described object data fetching management server 1.

As a result of the process, the 3D data generated by different application systems in the external storage device 300 are converted into the 3D data display format treatable in the knowledge management device 1000, and the management server 2 transmits the display information to the terminal 200 of the user and allows the display program of the terminal 200 to display the result.

For example, in Fig. 13, the 3D data A or the 3D data B represents the displayed result. Herein, with respect to the 3D data A and the 3D data B, there are the case where the positions of origins of the coordinate axes are different and the case where the coordinate systems are different as a rectangular coordinate system and a cylindrical coordinate system, or the like.

For example, as illustrated in the right portion of Fig. 13, in order arrange the 3D data A and the 3D data B in the same 3D coordinate system in a relative arrangement relationship illustrating the 3D data A and the 3D data B for describing the knowledge of the user, the user selects the 3D coordinate system by the standard coordinate selection 811 for selecting the coordinate system which the user desires to display finally. Next, in response to the pushing of the coordinate transform 812, the execution command for the process of displaying the 3D data A and the 3D data B in the same coordinate system is transmitted through the network 500 to the management server 2 and allows the feature point described object data fetching management server 1 to execute the coordinate transforming process of the 3D data stored in the 3D data fetching management server 1 of Fig. 2.

The execution result is displayed through the management server 2 on the terminal 200. The user visually checks the arrangement relationship between the 3D data A and the 3D data B which area converted into the same coordinate system and displayed, and by the pushing the movement/rotation manipulation 813 of Fig. 13 for the arrangement relationship which is desired by the user, the movement/rotation program of the terminal 200 is called, and the arrangement relationship is corrected. The examples of the methods of the coordinate transforming process and the movement/rotation process are generally known, and thus, the description thereof is omitted.

If there is no problem in the arrangement relationship displayed on the terminal 200, the user pushes the arrangement relationship determination 814. By this manipulation, the program of the terminal 200 temporarily stores the arrangement relationship between the 3D data A and the 3D data B in a temporary storage region of the local disk of the terminal.

Herein, as illustrated in the lower left portion of Fig. 13, in some cases, 3D data C may exist as a file of the external storage device 300 in the 3D data B. In the case where the 3D data C are not needed as an object that the user describes the knowledge, before the process of the coordinate transform 812, the program of the terminal 200 displays the selection screen of the 3D data as the object of the coordinate transform, and the process of the coordinate transform 812 is allowed to be performed by the designation of the user on the selection screen.

Before the coordinate transforming process, in the 3D data fetching management server 1, by the process of removing the 3D data C from the configuration of a file where the 3D data B and the 3D data C constitute one file, the 3D data C are removed and transmitted to the terminal 200.

Next, the user pushes the feature point generation 815 of Fig. 13 on the display screen of the terminal 200. The following feature point generation process by the user is already described with reference to Fig. 11 and the description thereof is omitted.

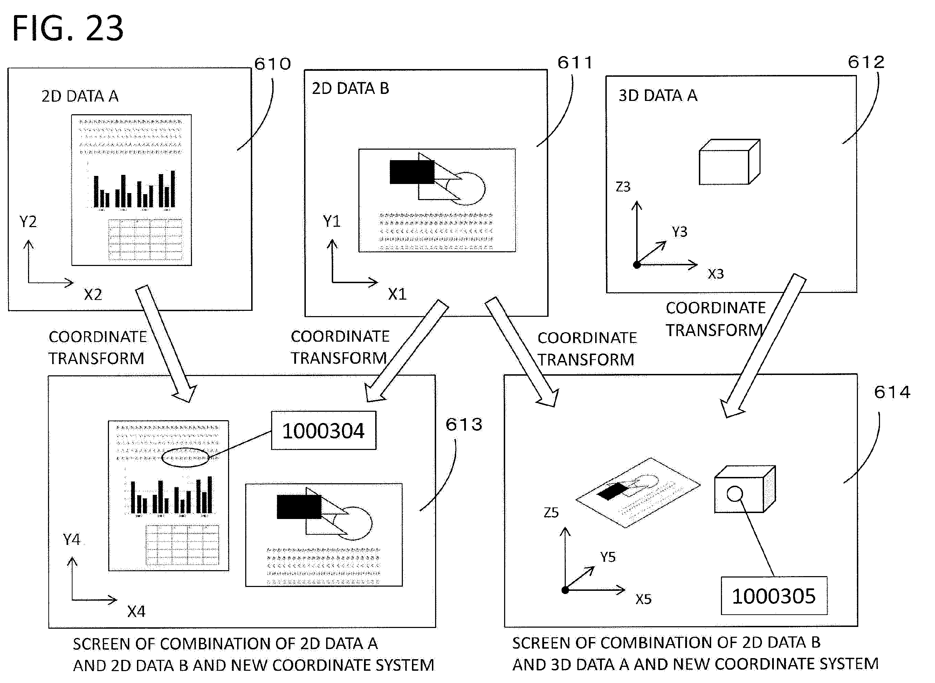

The case where the 2D data generated in another application system are converted into a common coordinate system is illustrated in 613 of Fig. 23. Similarly to the case of the 3D data, first, the terminal 200 of the user selects 2D data. The 2D data are converted into a uniform 2D data display format treatable in the knowledge management device 1000, and the converted data are stored in the feature point described object data fetching management server 1. The process of converting the 2D data stored in the storage device 300 outside the knowledge management device 1000 into the uniform 2D data display format treatable in the knowledge management device 1000 is already described in the embodiment of fetching the 2D data for the knowledge management device and describing the feature point, and the description thereof is omitted.

The feature point described object data fetching management server 1 determines the 2D coordinate system and the coordinate origin for the received 2D data by using the feature point described object data coordinate determining means 79 and transmits the coordinate information and the display information of the 2D data to the terminal 200 of the user, and thus, the terminal 200 of the user displays the 2D data on the display screen.

610 and 611 of Fig. 23 illustrates the results where the 2D data A and the 2D data B are displayed. In order to set the 2D data A and the 2D data B to be in the relative arrangement relationship illustrated in the 2D coordinate system, by selecting the 2D coordinate system by using the standard coordinate selection 811 and pushing the coordinate transform 812, the process of converting the 2D data A and the 2D data B into the same coordinate system is executed. The process of correcting the arrangement relationship is the same as that of the case of the 3D data. As a result of the process, the screen where the 2D data A and the 2D data B are combined in the new 2D coordinate system designated by the user is displayed on the terminal 200 (613 of Fig. 23).

614 of Fig. 23 illustrates the case of converting the 2D data and the 3D data generated by different application systems into the common coordinate system. First, in the terminal 200 of the user, the 2D data and the 3D data are selected, similarly to the above-described case, the 2D data B and the 3D data A are converted into the uniform display format treatable in the knowledge management device 1000 and stored in the feature point described object data fetching management server 1.

In order to set the 2D data B and the 3D data A to be in the relative arrangement relationship illustrated in the 3D coordinate system, by selecting the 3D coordinate system by using the standard coordinate selection 811 and pushing the coordinate transform 812, the process of converting the 2D data B and the 3D data A into the same coordinate system is executed. Next, the process of correcting the arrangement relationship of the 2D data B and the 3D data A is executed. As a result of the process, the screen where the 2D data B and the 3D data A are combined in the new 3D coordinate system designated by the user is displayed on the terminal 200 (614 of Fig. 23).

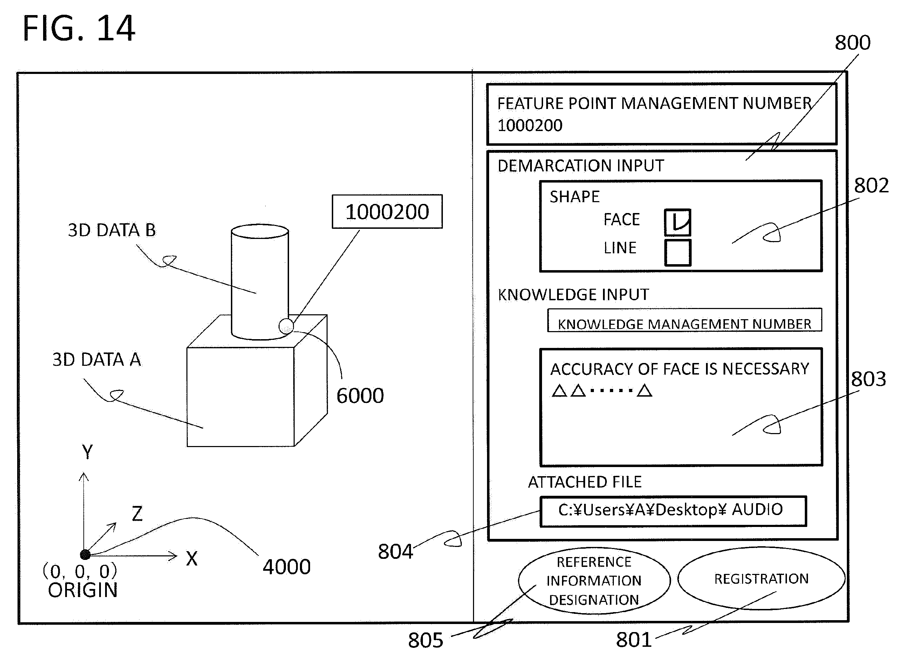

Fig. 14 illustrates the state where the feature point is generated and the knowledge corresponding to the feature point management number 1000200 is input by the user. Since the knowledge is knowledge about the arrangement relationship where two feature point described object data displayed after the execution of the coordinate transforming process of the different coordinate system, the editing of the arrangement relationship, and the file configuration editing are combined and displayed, the knowledge registration storing process is different from the storing process of Fig. 11.

In the knowledge management device 1000, the format converted feature point described object data are stored in the feature point described object data fetching management server 1 of Fig. 2. Information possessed in order to display the feature point described object data such as a coordinate system, a direction of a coordinate axis, an origin of the coordinate axis, or an arrangement coordinate of the feature point described object data stored in the feature point described object data fetching management server 1 is referred to as original coordinate information.

In the left diagram of Fig. 14, the arrangement of the 3D data A and the 3D data B is obtained by performing coordinate transform from the original coordinate information stored in the feature point described object data fetching management server 1. With respect to the coordinate-transformed arrangement, as illustrated in Fig. 14, the feature point 6000 is generated, and the feature point management number 1000200 is affixed.

Fig. 15 illustrates an example of an accumulation structure for using the knowledge data in the knowledge management device 1000. A structure of separating and storing the geometric shape information, the feature point, and the knowledge added at the feature point of the feature point described object data in order to use the accumulated knowledge is illustrated.

As the feature point described object data which are information of the feature point described object data structure, the data originally included in the file stored in the storage device 300 outside of the knowledge management device 1000 are stored as the feature point described object data management information in the feature point described object data storage server 3. The feature point described object data management information includes the geometric shape data and the original coordinate information in the file of the feature point described object data.

In Fig. 15, as the knowledge display relationship information, the coordinate information such as the coordinate system or the arrangement of the feature point described object data determined at the time of describing the knowledge are stored for each knowledge management number. This is because the pieces of knowledge according to the arrangement of the feature point described object data are different with respect to the same feature point described object data and this is configured in order that the different pieces of knowledge can be allowed to be accumulated by a combination with different feature point described object data. Both of the combined feature point described object data have the same feature point management number, so that, if the feature point management number is specified, the feature point described object data storage server 3 searches for the feature point described object data and performs the process of displaying the corresponding feature point described object data and the feature point on the terminal 200 according to the coordinate information of the feature point described object data included in the feature point described object data.

On the other hand, the knowledge management information, the knowledge information, and the feature point display information are defined in the knowledge data structure of Fig. 15. These are stored in the knowledge storing database server 4. The knowledge management information includes a relationship between the data name and the feature point management number.

The knowledge information may have a plurality of the knowledge management numbers in order to accumulate a plurality of pieces of knowledge with respect to one feature point management number. In addition, the knowledge information is defined so that a plurality of attached files are attached with respect to one knowledge management number.

The feature point display information of Fig. 15 has the feature point geometric shape type or the coordinate information for every feature point management number, and even with respect to the feature point described object data where the relationship with the feature point management number is not stored, the data structure for visually displaying the feature point and utilizing the knowledge is defined by the coordinate information of the feature point.

As described above, by the data structure illustrated in Fig. 15, as the knowledge utilizing request from the terminal 200 of the user, with respect to, for example, the data name or the feature point management number, the knowledge storage server 5 allows the feature point described object data coordinate transforming means 75 of the knowledge storage server 5 to perform the coordinate transform on the associated feature point described object data and feature point from the designated data name or feature point management number by using the knowledge display relationship information in the feature point described object data structure and the feature point display information and displays the result on the terminal 200.

By the process, as well as the searching for the feature point described object data associated with the knowledge, the user can utilize the knowledge which can be accumulated in association with the feature point described object data which are separated from the knowledge by utilizing only the data of the knowledge, displaying the feature point in the separated feature point described object data which is different from the feature point described object data, and storing the knowledge as the feature point described object data which are separated from the feature point. At this time, by the editing function for the to-be-utilized knowledge, the to-be-utilized knowledge is corrected and accumulated. In addition, in the case where the reference feature point or the reference knowledge is designated to the feature point or knowledge which is to be utilized or in the case where the feature point or knowledge which is to be utilized is designated as the reference feature point or the reference knowledge, the reference relationship is stored in the after-utilization feature point or knowledge. With respect to the storage of the reference relationship to the after-utilization feature point or knowledge, the reference relationship which is not to be stored according to the user's instruction that the utilization is not needed may be selected.

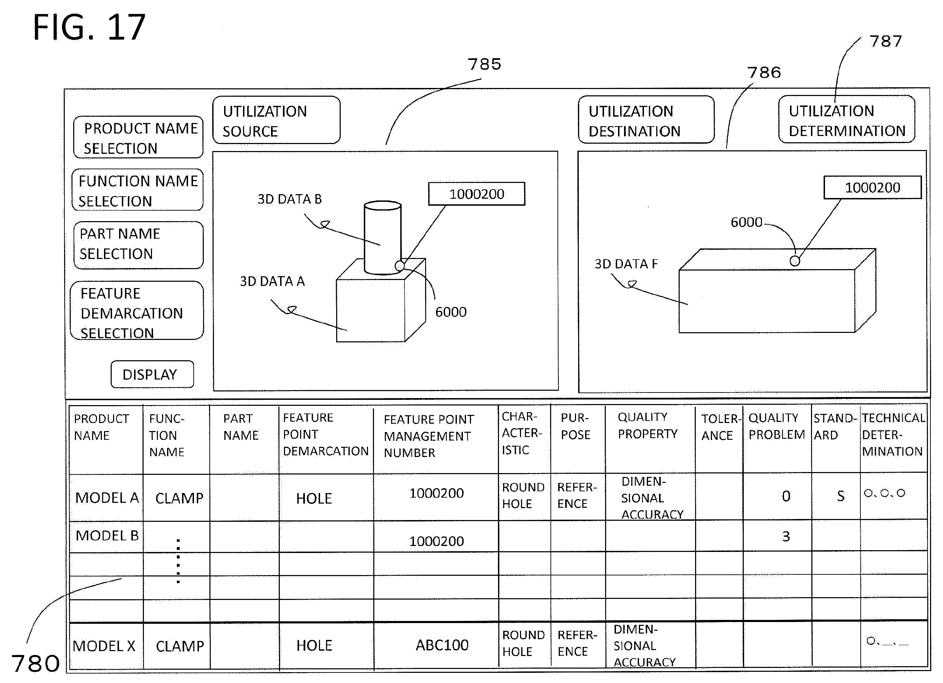

For example, Fig. 17 is a diagram illustrating the utilizing method. First, the user selects the product name or the part name in the terminal 200 and allows 3D data and the feature point to be displayed on the region 785 which is a display site of the utilization source. Next, the displayed feature point and the knowledge are identified in the knowledge region 780.

Subsequently, by selection of the part name of which the knowledge is to be utilized from the terminal 200 of the user, the knowledge of the designated part is searched for by the knowledge searching means 76 of the knowledge storage server 5, and the result is displayed on the terminal 200.

At this time, in the case where the coordinate system of the 3D data B of the utilization source of the knowledge and the coordinate system of the 3D data F of the utilization destination are different, the feature point described object data coordinate transforming means 75 arranged in the knowledge storage server 5 performs the coordinate transform in advance and transmits the result thereof through the network 500 to the terminal 200 of the user.

More specifically, the 3D data F and the feature point management number 1000200 and the feature point 6000 accumulated in the 3D data B of the utilization source are displayed on the display region 786 of the utilization destination. At this time, in the case where a feature point or knowledge is already accumulated in the 3D data F, information of such a feature point is also displayed.

Next, in Fig. 17, according to the pushing of the utilization determination 787, by the program of the terminal 200, the feature point management number 1000200 which is a temporary feature point management number and the coordinate information of the feature point are transmitted through the network 500 to the management server 2, and the management server 2 transmits the information to the knowledge storage server 5.

In the knowledge storage server 5, a knowledge utilizing means 77 performs a process of reassigning the temporary feature point management number 1000200 of the 3D data F to a new unique number. At this time, the temporary feature point management number 1000200 is stored as the utilization source feature point management number in the newly-reassigned feature point management number, and the newly-reassigned feature point management number of the 3D data F is stored as the utilization destination feature point management number in the feature point management number 1000200 of the reference source, so that the utilization relationship of the knowledge is recorded. In addition, a process of copying the knowledge accumulated in the feature point management number 1000200 of the 3D data B of the utilization source to the newly-reassigned feature point management number of the 3D data F is performed, and the accumulation in the knowledge storage server 5 is performed.

At this time, performed is a process of affixing the reference knowledge management number, the reference-target knowledge management number, the reference feature point management number, and the reference-target feature point management number which are the reference information recorded in the management information of the feature point 6000 and the knowledge described in the feature point 6000 of the utilization source to the reference information of the feature point and the knowledge of the utilization destination, and the reference relationship between the feature point and the knowledge of the utilization source is stored in the reference relationship between the feature point and the knowledge of the utilization destination.

In addition, Fig. 16 illustrates an example of the search screen, and in the search process, for example, in the terminal 200 of the user, the search request command of designation of the word described in the knowledge or the feature point demarcation which is the information accumulated as the knowledge executes the knowledge searching means 76 to search the database of the knowledge storing database server 4. The execution result is transmitted from the management server 2 to the terminal 200 issuing the request for the search result through the network 500 and the network 700, and in the terminal 200, as illustrated in Fig. 16, the searched 3D data are displayed in the region 781, and a list of the feature points on the 3D data is displayed in the region 780.

As the method of searching the word designated from the knowledge by the user, for example, full text search described in the knowledge may be used. Alternatively, the knowledge searching means 76 is executed to search the knowledge including the word defined in the knowledge classification exemplified in Fig. 5 which is registered as a master in the knowledge classification management by the terminal 100 of Fig. 2 such as a processing method as an item name of the knowledge input form 557 of Fig. 12 describing the knowledge or a press process as the data thereof.

As illustrated in Fig. 9, as the knowledge information of the feature point described in the feature point described object data, lines, corners, R, faces, gaps, step difference, material, color, surface coating, quenching, or the like is defined in the feature point demarcation indicating the type of the feature point. The method of definition is already described above with reference to Fig. 10.

In addition, in the embodiment, by inputting feature point demarcation as initial classification at the coordinate of the feature point as the feature point demarcation, knowledge as well as geometry (geometric shape) can be freely registered, so that searching thereof can be easily performed. It is important to clarify what the feature point represents. Therefore, the knowledge management device 1000 is configured so that the word of the knowledge classification can be registered at the feature point.

In the case where a directory and a file name of a document, a table, a graph, a figure, an image, a video, or 3D data are recorded as knowledge in the attached file, according to the designation of the terminal 200 of the user, the designated data is searched for from the knowledge storage server 5, and the result is displayed in the terminal 200.

In addition, the user visually determines the display result of Fig. 16 from the region 780 and designates, for example, a to-be-displayed model A. The terminal 200 transmits the part name of the designated model A through the network to the management server 2. The management server 2 makes the knowledge storage server 5 extract the designated part name and the feature point management number accumulated in association with the part name by the knowledge searching means 76 in the feature point described object data storage server 3 storing the feature point described object data including the designated part name. In addition, the knowledge searching means 76 searches for all the feature point described object data including the feature point management number and transmits the result to the management server 2.

The management server 2 transmits the search result to the terminal 200 and displays the associated feature point described object data together with the feature point as the relation knowledge in the region 782.

In this manner, the user can search for the necessary knowledge from the knowledge management device 1000 by using the terminal 200 and can allow the feature point described object data to be visually displayed. In addition, by designating the displayed part name, feature point, or the like from the display result, for example, other data recorded as an addition to the knowledge of the feature point or the feature point or the knowledge designated as reference information can be allowed to be displayed. Namely, it is possible to identify from the knowledge the data that the user has not seen. The user performs visual perception through the 3D data, so that the user can recognize the knowledge that the user have no experience about.

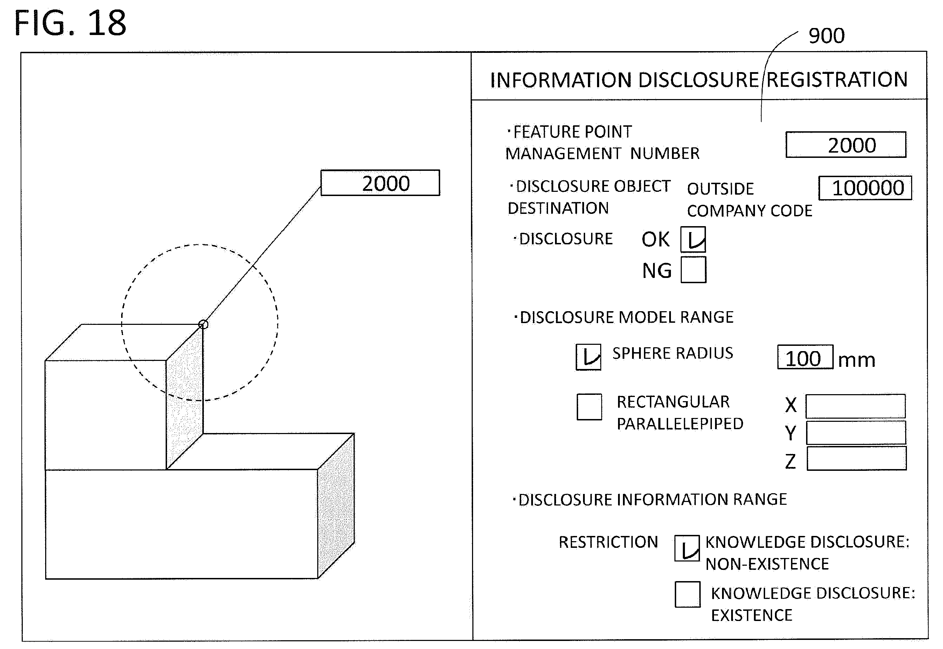

Fig. 18 illustrates a screen of the information disclosure registration of the knowledge management device 1000. The user displays Fig. 18 from a menu in the terminal 200. Fig. 18 illustrates a state where the user describes the feature point 2000. The user can restrict whether or not to disclose the information on the knowledge about the feature point management number 2000 with respect to a specified outside company according to the display of the information disclosure registration area 900 in the right side of Fig. 18.

In a general disclosure restricting method, there is a problem in that the file of the feature point described object data is used as a unit of disclosure, and shape information or the like exceeding the one required by the outside companies is transmitted. In the knowledge management system 1000, like an example shown in the information disclosure registration area 900, the user can manage whether or not to disclose the feature point 2000 by the terminal 200, with respect to the information disclosure in more detailed units of a feature point than that of the file of the feature point described object data.

For example, with respect to the feature point 2000, if the user can disclose the feature point at the outside-company code 100000 in Fig. 18, the registration is performed, the to-be-disclosed disclosure data range is set as a sphere having a radius of 100 mm centered at the feature point 2000, and the disclosure control means 78 of the knowledge storage server 5 executes the restriction of not disclosing the knowledge recorded at the feature point 100000 by inputting check mark in the knowledge non-disclosure.

In this manner, the information on the information disclosure registration is transmitted from the terminal 200 through the network 500 to the management server 2, and the management server 2 commands the knowledge storage server 5 to execute the disclosure control means 78. The disclosure control means 78 searches for the feature point described object data including the feature point 2000 of the feature point described object data storage server 3 and cuts the geometric shape of the feature point described object data on the spherical surface having a radius of 100 mm centered at the coordinate of the feature point. The cut geometric shape is transmitted to the management server 2. The management server 2 displays only the 3D data of the cut portion on the terminal 200 of the user through the network 500. The user can check the display result and transmit the information to the company of the outside-company code 100000.

At this time, since the knowledge non-disclosure is checked as a restriction of the disclosure information range in Fig. 18, the disclosure control means 78 functions so that the information on the knowledge recorded at the feature point 2000 is not transmitted, and only the information matching with the designated contents of the information disclosure registration designated in the terminal 200 by the user is transmitted to the management server 2.

### INDUSTRIAL APPLICABILITY

The present invention can be used for manufacturing industries of heavy industrial products, plants, ships, vehicles, electrical products, electronic products, and the like, accumulation of patient medical charts information in the medical field, movies, comics, animation, games, advertisement, or education.

### EXPLANATIONS OF REFERENCE NUMERALS

1: feature point described object data fetching management server
2: management server
3: feature point described object data storage server
4: knowledge storing database server
5: knowledge storage server
6: access control server
33: lead line of feature point
51: feature point described object data storage unit
52: knowledge storage unit
53: word storage unit
54: feature point described object data fetching storage unit
72: knowledge classification managing means
73: knowledge describing means
75: feature point described object data coordinate transforming means
76: knowledge searching means
77: knowledge utilizing means
78: disclosure control means
79: feature point described object data coordinate determining means
80: feature point described object data format converting means
100: terminal
200: terminal
300: storage device
500: network
700: intra-company LAN
800: knowledge input form
1000: knowledge management device
5000: feature point
6000: feature point

## Claims

1. A knowledge management device managing knowledge by using 2D data, wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data,
wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data,
wherein, with respect to the following feature point, a coordinate of a point which a person designates in order to explain the knowledge in a coordinate system of 2D data is referred to as a feature point, and
wherein the knowledge management device comprises:
a feature point describing means which describes the feature point for describing at least one or more pieces of knowledge about 2D data in the same coordinate system in a coordinate space for display of the 2D data;
a knowledge describing means which describes the knowledge in the feature point; and
a knowledge storing means which stores the knowledge and the 2D data in association with each other by affixing a unique feature point management number to the feature point.

2. A knowledge management device managing knowledge by using 3D data, wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI,
wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 3D data,
wherein, with respect to the following feature point, a coordinate of a point which a person designates in order to explain the knowledge in a coordinate system of 3D data is referred to as a feature point, and
wherein the knowledge management device comprises:
a feature point describing means which describes the feature point for describing at least one or more pieces of knowledge about 3D data in the same coordinate system in a coordinate space for display of the 3D data;
a knowledge describing means which describes the knowledge in the feature point; and
a knowledge storing means which stores the knowledge and the 3D data in association with each other by affixing a unique feature point management number to the feature point.

3. The knowledge management device according to claim 1, further comprising:
a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point);
a knowledge describing means which describes the knowledge in the higher feature point; and
a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number.

4. The knowledge management device according to any one of claims 1 to 3, wherein 2D data or 3D data as an object of description of the feature point hereinafter are referred to as feature point described object data, and
wherein the knowledge management device further comprises:
a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge; and
a reference knowledge storing means which stores the reference relationship and the reference data.

5. The knowledge management device according to any one of claims 1 to 4, further comprising a coordinate transformation feature point describing means which transforms at least two or more feature point described object data produced by different coordinate systems into a common coordinate system and describes the feature point.

6. The knowledge management device according to any one of claims 1 to 5, further comprising a knowledge utilizing storing means which stores the feature point described object data and the knowledge for using the accumulated knowledge through the feature point management number and utilizes the knowledge.

7. The knowledge management device according to any one of claims 1 to 6, further comprising:
a knowledge classification affixing means of a classification name or the like of the knowledge;
a knowledge registering means which describes the knowledge by selecting a word from a knowledge classification managing means; and
a knowledge searching means which searches and displays the associated feature point described object data from knowledge classification or contents described as the knowledge.

8. The knowledge management device according to any one of claims 1 to 7, further comprising a knowledge disclosure restricting means having a disclosure control means which performs space definition by using a coordinate of the feature point to disclose a portion of the feature point described object data or a portion of the knowledge to another person.

9. A terminal for a knowledge management device managing knowledge by using 2D data or 3D data,
wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data,
wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI,
wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data or 3D data,
wherein, with respect to the following feature point, a coordinate of a point which a person designates in order to explain the knowledge in a coordinate system of 2D data or 3D data is referred to as a feature point, and
wherein the knowledge management device comprises:
a feature point describing means which describes the feature point for describing at least one or more pieces of knowledge about 2D data in the same coordinate system in a coordinate space for display of the 2D data;
a knowledge describing means which describes the knowledge in the feature point;
a knowledge storing means which stores the knowledge and the 2D data in association with each other by affixing a unique feature point management number to the feature point;
a feature point describing means which describes the feature point for describing at least one or more pieces of knowledge about 3D data in the same coordinate system in a coordinate space for display of the 3D data;
a knowledge describing means which describes the knowledge in the feature point;
a knowledge storing means which stores the knowledge and the 3D data in association with each other by affixing a unique feature point management number to the feature point;
a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point);
a knowledge describing means which describes the knowledge in the higher feature point; and
a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number,
wherein 2D data or 3D data as an object of description of the feature point hereinafter are referred to as feature point described object data, and
wherein the knowledge management device further comprises:
a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge;
a reference knowledge storing means which stores the reference relationship and the reference data;
a coordinate transformation feature point describing means which transforms at least two or more feature point described object data produced by different coordinate systems into a common coordinate system and describes the feature point;
a knowledge utilizing storing means which stores the feature point described object data and the knowledge for using the accumulated knowledge through the feature point management number and utilizes the knowledge;
a knowledge classification affixing means of a classification name or the like of the knowledge;
a knowledge registering means which describes the knowledge by selecting a word from a knowledge classification managing means;
a knowledge searching means which searches and displays the associated feature point described object data from knowledge classification or contents described as the knowledge; and
a knowledge disclosure restricting means having a disclosure control means which performs space definition by using a coordinate of the feature point to disclose a portion of the feature point described object data or a portion of the knowledge to another person,
wherein the terminal comprises:
a feature point input means; and
a knowledge input means, and
wherein information input from each means is transmitted from the terminal to the knowledge management device, the primary and higher feature point describing means, the knowledge describing means for the primary and higher feature points, the knowledge storing means for the knowledge described in the primary and higher feature points, the reference feature point knowledge describing means, the reference knowledge storing means, the coordinate transformation feature point describing means, the knowledge utilizing storing means, the knowledge classification affixing means, the knowledge registering means, the knowledge searching means, and the knowledge disclosure restricting means included in the knowledge management device perform processes described in the claims based on the transmitted information, the knowledge management device transmits results of the processes to the terminal, and the terminal displays the transmitted results.

10. A program for a knowledge management device managing knowledge by using 2D data or 3D data,
wherein the following described 2D data denote 2D digital data produced by software which produces, edits, and records digital data in a 2D coordinate system such as books, documents, pictures, videos, figures, layout diagrams, blueprints, caricatures, MRI, X-ray, or CT or snapshot or display data for printing of a display screen of 3D digital data,
wherein the following described 3D data denote 3D data which are produced and edited by the creativity of a person with a computer aided design (CAD) system, a computer graphics (CG) system, or the like, 3D data of tangible existing objects measured by a 3D measurement instrument using measurement technology such as laser or ultrasonic waves, 3D data which are processed so as for a person to be easy to visually recognize such as 3D data converted from 2D data measured by measurement technology used in medical instruments such as CT or MRI,
wherein the following described knowledge is things that persons noticed, know, have heard, have seen, knew, understood, determined, thought, or the like and a description representation of the knowledge denotes digital representations such as characters or numbers described in a text or fixed input format, files of audio, video, tables, graphs, or figures, or associated 2D data or 3D data,
wherein, with respect to the following feature point, a coordinate of a point which a person designates in order to explain the knowledge in a coordinate system of 2D data or 3D data is referred to as a feature point, and
wherein the knowledge management device comprises:
a feature point describing means which describes the feature point for describing at least one or more pieces of knowledge about 2D data in the same coordinate system in a coordinate space for display of the 2D data;
a knowledge describing means which describes the knowledge in the feature point;
a knowledge storing means which stores the knowledge and the 2D data in association with each other by affixing a unique feature point management number to the feature point;
a feature point describing means which describes the feature point for describing at least one or more pieces of knowledge about 3D data in the same coordinate system in a coordinate space for display of the 3D data;
a knowledge describing means which describes the knowledge in the feature point;
a knowledge storing means which stores the knowledge and the 3D data in association with each other by affixing a unique feature point management number to the feature point;
a higher feature point describing means which describes a secondary order feature point in the group of two or more primary feature points described in one or more 2D data, in addition, describes a higher order feature point in the group of two or more arbitrary-order feature points (hereinafter, referred to as a higher feature point as distinguished from the primary feature point);
a knowledge describing means which describes the knowledge in the higher feature point; and
a knowledge storing means which affixes a unique feature point management number to each higher feature point described in the 2D data, affixes a unique knowledge management number to each of one or more pieces of knowledge described in each feature point, and stores the knowledge in association with the 2D data through the feature point management number and the knowledge management number,
wherein 2D data or 3D data as an object of description of the feature point hereinafter are referred to as feature point described object data,
wherein the knowledge management device further comprises:
a reference feature point knowledge describing means which, at the time of describing the feature point or the feature point and knowledge in one feature point described object data, describes a new feature point or new feature point and knowledge in a different feature point described object data or selects the feature point having already been produced in the different feature point described object data or the knowledge described in the feature point as a reference of the feature point or the knowledge to apply a reference relationship as reference data of to-be-described knowledge;
a reference knowledge storing means which stores the reference relationship and the reference data;
a coordinate transformation feature point describing means which transforms at least two or more feature point described object data produced by different coordinate systems into a common coordinate system and describes the feature point;
a knowledge utilizing storing means which stores the feature point described object data and the knowledge for using the accumulated knowledge through the feature point management number and utilizes the knowledge;
a knowledge classification affixing means of a classification name or the like of the knowledge;
a knowledge registering means which describes the knowledge by selecting a word from a knowledge classification managing means;
a knowledge searching means which searches and displays the associated feature point described object data from knowledge classification or contents described as the knowledge; and
a knowledge disclosure restricting means having a disclosure control means which performs space definition by using a coordinate of the feature point to disclose a portion of the feature point described object data or a portion of the knowledge to another person, and
wherein the program allows the terminal and a computer of the knowledge management device to function as the primary and higher feature point describing means, the knowledge describing means for the primary and higher feature points, the knowledge storing means for the knowledge described in the primary and higher feature points, the reference feature point knowledge describing means, the reference knowledge storing means, the coordinate transformation feature point describing means, the knowledge utilizing storing means, the knowledge classification affixing means, the knowledge registering means, the knowledge searching means, and the knowledge disclosure restricting means.
